# EUROPEAN PATENT APPLICATION

(11) **EP 1 152 070 A1**
(43) Date of publication of application: **07.11.2001**
(21) Application number: 00951931.5
(22) Date of filing: 10.08.2000
(51) Int. Cl.: C25D 1/22, H05K 1/09

(54) **ELECTROLYTIC COPPER FOIL WITH CARRIER FOIL AND METHOD FOR MANUFACTURING THE SAME AND COPPER-CLAD LAMINATE USING THE ELECTROLYTIC COPPER FOIL WITH CARRIER FOIL**

(30) Priority: 31.08.1999 JP 24433199
(71) Applicant: Mitsui Mining & Smelting Co., Ltd., Tokyo 141-8584 (JP)
(72) Inventor: KATAOKA, Takashi, Mitsui Mining & Smelting Co. Ltd, Ageo-shi, Ageo-shi, Saitama 362-001 (JP); HIRASAWA, Yutaka, Mitsui Mining & Smelting Co. Ltd, Ageo-shi, Saitama 362-0013 (JP); YAMAMOTO, Takuya, Mitsui Mining & Smelting Co. Ltd, Ageo-shi, Saitama 362-001 (JP); IWAKIRI, Ken-ichiro, Mitsui Mining & Smelting Co., Ageo-shi, Saitama 362-001 (JP); HIGUCHI, Tsutomu, Mitsui Mining & Smelting Co. Ltd, Ageo-shi, Saitama 362-0021 (JP); SUGIMOTO, Akiko, Mitsui Mining & Smelting Co., Ltd, Ageo-shi, Saitama 362-0021 (JP); YOSHIOKA, Junshi, Mitsui Mining & Smelting Co. Ltd, Ageo-shi, Saitama 362-0021 (JP); OBATA, Shin-ichi, Mitsui Mining & Smelting Co.,, Ageo-shi, Saitama 362-0021 (JP); TOMONAGA, Sakiko, Mitsui Mining & Smelting Co. Ltd, Ageo-shi, Saitama 362-0021 (JP); DOBASHI, Makoto, Mitsui Mining & Smelting Co. Ltd., Ageo-shi, Saitama 362-0021 (JP)
(74) Representative: Allard, Susan Joyce
(86) International application number: JP0005363
(87) International publication number: WO0116402

(57) **Abstract**

To improve peel stability of a carrier foil after press-forming at a temperature higher than 300°C, poor peel stability being a drawback of conventional electrodeposited copper foils with peelable carrier, and to provide an electrodeposited copper foil with carrier in which a carrier foil can be peeled stably by application of a small peel force. The objects are attained by use of an electrodeposited copper foil with peelable carrier in which an adhesive interface layer is formed on a carrier foil by use of thiocyanuric acid and an electrodeposited copper foil layer 5 is deposited on the adhesive interface layer.

## Description

### Technical Field

The present invention relates to electrodeposited copper foil with carrier; to a method for producing the electrodeposited copper foil with carrier; and a laminate and a similar product employing the electrodeposited copper foil with carrier.

### Background Art

Conventionally, electrodeposited copper foil with carrier has been employed as a material for producing printed wiring boards, which are widely used in the electric and electronic industries. In general, electrodeposited copper foil with carrier is produced by bonding copper foil, through hot-pressing, onto an electrically insulating polymer material substrate such as glass-epoxy substrate, phenolic polymer substrate, or polyimide, to thereby form a copper-clad laminate, and the thus-prepared laminate is used for producing printed wiring boards.

In hot-pressing, a copper foil, a prepreg (substrate) which is semi-cured to be a B-stage, and press plates for lamination (hereinafter referred to as simply "press plates") are laid-up in a multilayered manner, and the copper foil and the prepreg are hot-press-bonded at high temperature and pressure (hereinafter the step may be referred to as "press-forming"), thereby forming a copper-clad laminate. When wrinkles are in turn generated in the copper foil to be pressed, cracks are generated in the wrinkled portions, thereby possibly causing bleeding of resin from a prepreg, or open circuit of a formed electric circuit during a post-etching step involved in production steps of printed wiring boards.

The thinner the copper foil, the more serious the problems caused by wrinkles generated in the copper foil. Thus, the copper foil with carrier has been attracting attention because these problems can be eliminated, and because penetration of foreign matter through the copper foil is prevented throughout the process of hot-pressing. Specifically, the electrodeposited copper foil with carrier has a structure such that a carrier foil is bonded to an electrodeposited copper foil so as to form a sheet. Such foils are subjected to press-forming as they are, and the carrier foil is removed just before the copper foil is etched to produce a copper circuit. Thus, there can be prevented generation of wrinkles in the electrodeposited copper foil during handling or pressing thereof, as well as surface staining of a produced copper-clad laminate.

Carrier foil this term is used throughout the present description is used in a form such that one surface of the carrier foil were as if bonded to one surface of an electrodeposited copper layer. The "carrier foil" has the characteristics described below. In order to produce the electrodeposited copper foil with carrier according to the present invention, copper is electrodeposited on one surface of the carrier foil. Thus, at least one surface of the carrier foil is electrically conductive. The electrodeposited copper foil passes through a continuous production line, and bonding of the carrier foil to the copper foil is maintained at least until completion of the production of a copper-clad laminate. The carrier foil facilitates handling of the electrodeposited copper foil and is very effective in reinforcing and protecting the copper foil. Therefore, the carrier foil must exhibit a certain level of mechanical strength. Any material may be used as the carrier foil, so long as the material satisfies the aforementioned conditions, and generally, metal foils may serve well as the carrier foil. However, the carrier foil is not limited only to metal foils.

Electrodeposited copper foils with carrier are generally divided into two types; i.e., peelable type and etchable type. Briefly, the difference between the two types of foils lies in the method for removing the carrier after completion of press-forming. In peelable foils, the carrier is removed by peeling, whereas in etchable foils, the carrier is removed by etching.

However, the peel strength of conventional peelable foils after completion of press-forming varies considerably, and a preferable strength of 50-300 gf/cm is generally required. In some cases, a carrier foil cannot be removed from the copper-clad laminate. Thus, conventional peelable foils have a drawback; i.e., target peel strength is difficult to attain. The drawback prevents the widespread use of the electrodeposited copper foil with peelable carrier employed for general use.

Causes of variation in peel strength of a carrier foil will next be described. Conventional electrodeposited copper foil with carrier, regardless of whether the carrier is peelable or etchable, have a metallic―e.g., zinc-containing―adhesive interface layer between the carrier foil and the electrodeposited copper foil. The amount of metal components forming the adhesive interface layer determines, with slight dependence on the type of the carrier foil, whether the formed copper foils with carrier are peelable or etchable.

In many cases, such a metallic adhesive interface layer is formed electrochemically; i.e., through electrodeposition by use of a solution containing a predetermined metallic element. However, in electrodeposition, controlling the amount of deposition on a very minute level is difficult, and reproduction of the deposition is unsatisfactory as compared with other methods for forming the adhesive interface layer. In addition, the boundary line of the required deposition amount determining whether the formed copper foil with carrier becomes peelable or etchable is difficult to adjust; i.e., small variations in amount of a metallic component contained in the adhesive interface layer determine the type of the formed copper foil with carrier. Thus, stable peeling performance may be difficult to attain. From another point of view, such a carrier foil is removed by peeling after completion of press-forming, typically at a temperature as high as 180°C under high pressure and 1 to 3 hours. Components contained in the carrier foil and copper atoms contained in the electrodeposited copper foil may mutually diffuse through the adhesive interface layer. Such mutual diffusion strengthens the adhesion, thereby enabling an increase in peel strength.

In recent years, ever-increasing demand for downsizing of electronic and electric apparatus has led to strong demand for an increase in the number of layers in printed wiring boards serving as essential parts of devices; an increase in density of circuits formed from copper foil; and an increase in the density of mounted elements. Since the amount of heat released from mounted elements increases, printed wiring boards which serve as internal parts in the devices must have high heat resistance. Thus, heat-resistant substrates such as a substrate formed of BT resin, a Teflon substrate, and a polyimide substrate have been employed. In general, copper-clad laminates for fabricating printed wiring boards tend to be pressed at higher temperatures. In consideration of the situation as described above, use of conventional electrodeposited copper foils with peelable carrier might be further limited.

Meanwhile, copper foils with etchable carrier require dedicated etching facilities, and the time and cost for etching are considerably expensive. Thus, employment of copper foils with etchable carrier raises the overall production costs of target products, and such foils cannot be readily applied to production of a variety types of target products.

### Brief Description of the Drawings

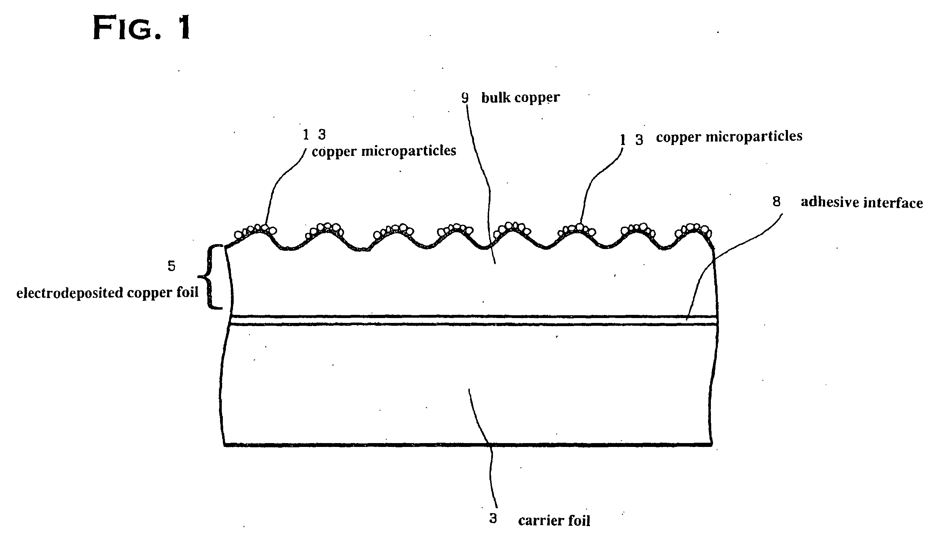

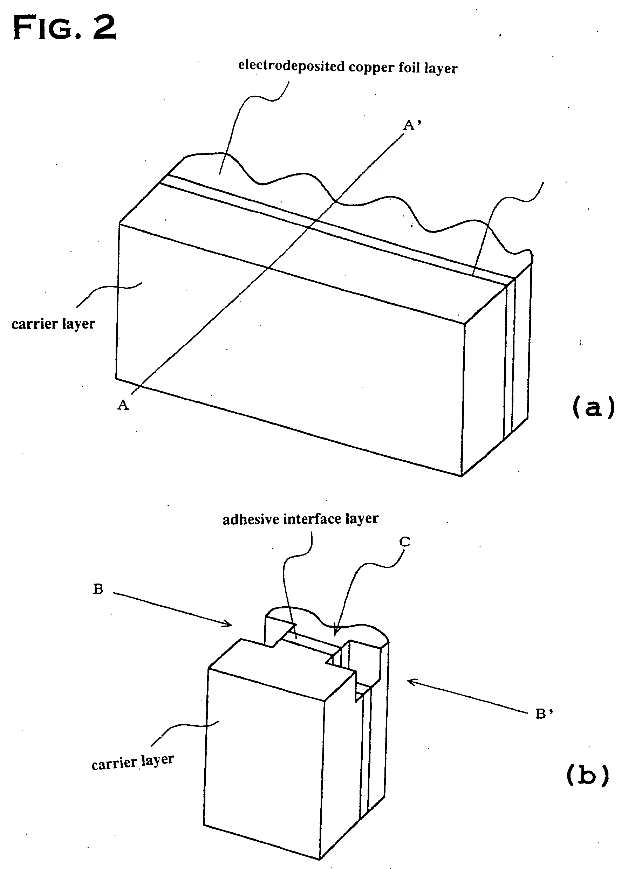

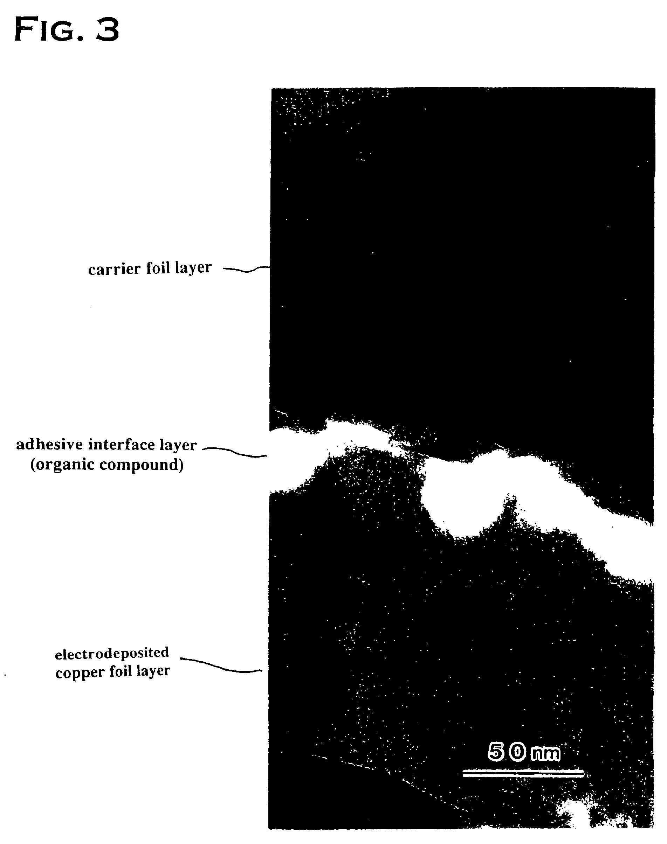

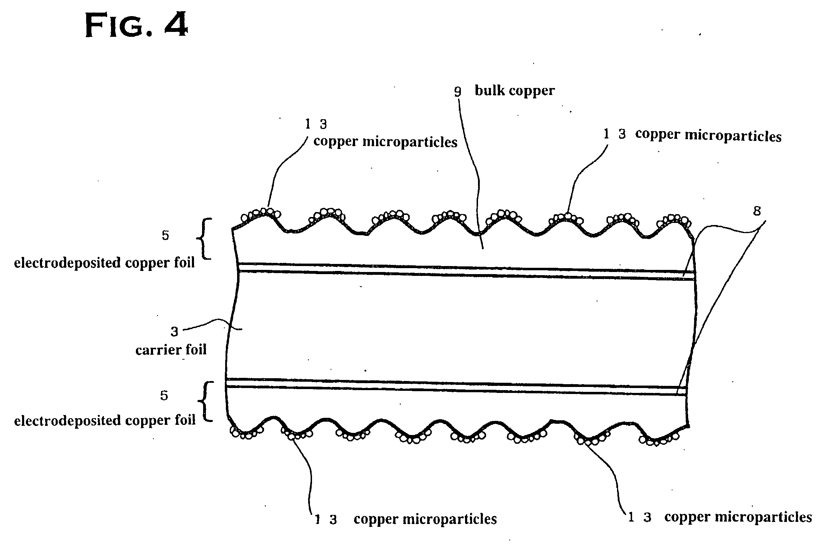

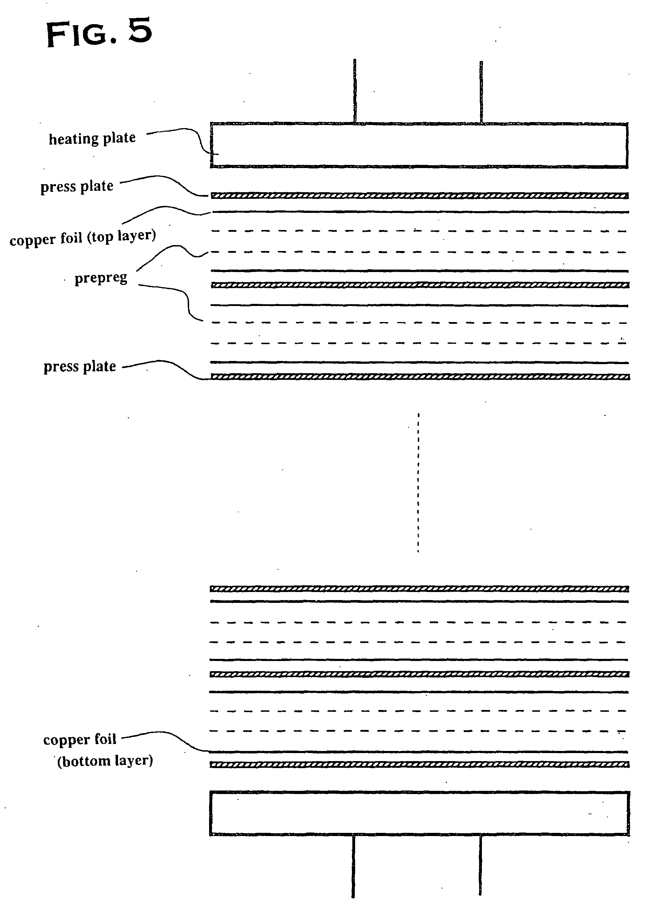

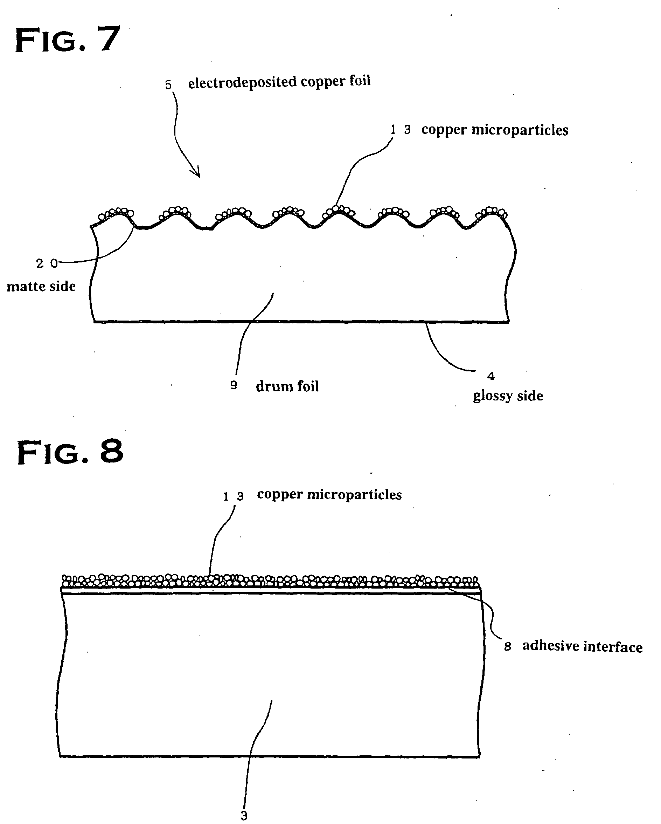

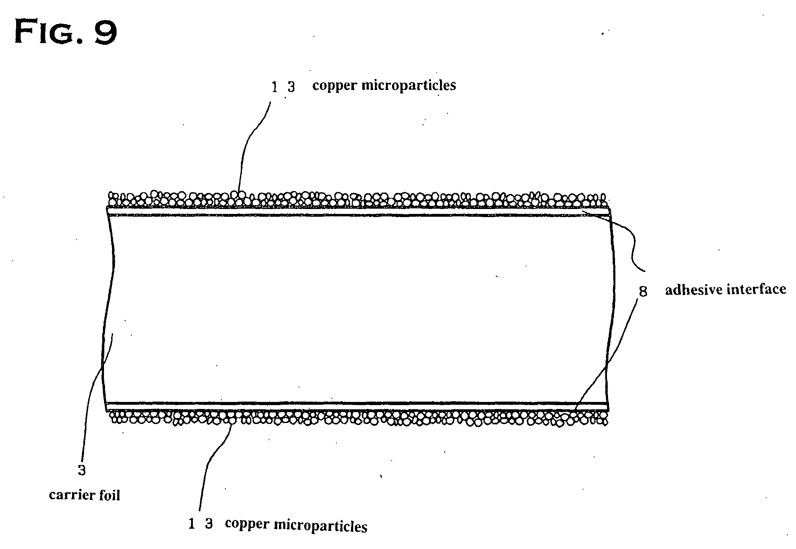

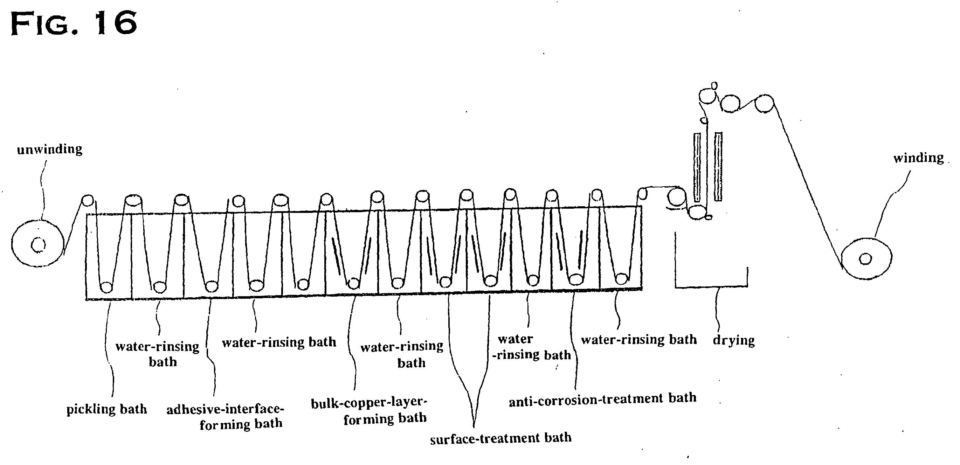

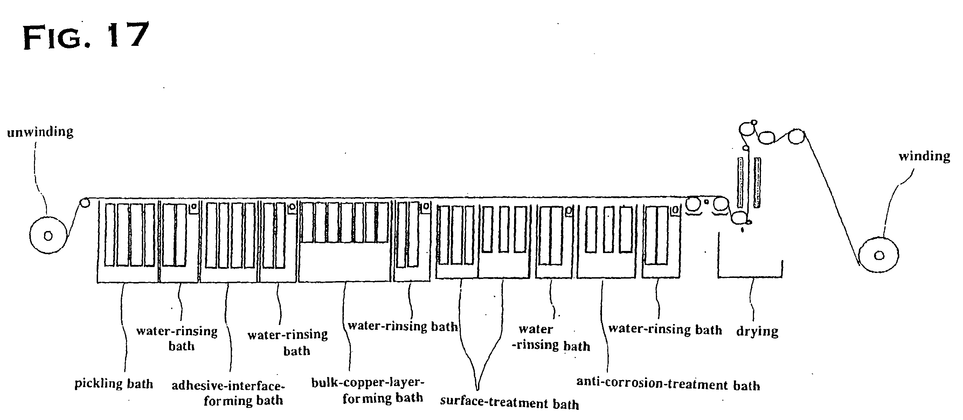

Fig. 1 is a schematic cross-sectional view of an electrodeposited copper foil with carrier. Fig. 2 illustrates a method for preparing a sample which is subjected to TEM observation. Fig. 3 shows a TEM image of an adhesive interface layer of the sample. Fig. 4 is a schematic cross-sectional view of an electrodeposited copper foil with carrier. Each of Figs. 5, 6, 11, and 12 is a schematic view of a laid-up structure subjected to press-forming. Fig. 7 is a schematic cross-sectional view of a typical electrodeposited copper foil serving as a carrier foil employed in the present invention. Each of Figs. 8 to 10, 13, and 15 is a schematic cross-sectional view of an electrodeposited copper foil with carrier. Fig. 14 is a schematic view of a circuit formed by etching a copper foil. Each of Figs. 16 to 20 is a schematic cross-sectional view of an apparatus used for producing an electrodeposited copper foil with carrier.

### Summary of the Invention

The present inventors have conducted earnest studies in order to solve the problems of conventional electrodeposited copper foils with peelable carrier. The inventors have previously proposed an electrodeposited copper foil with carrier in which the carrier foil and the copper foil are bonded via an organic adhesive interface, which maintains the peel strength at a low level. However, recently, a copper-clad laminate has been produced from a substrate such as a double-layered flexible substrate or a Teflon substrate and an electrodeposited copper foil with carrier, by pressing these layers at a temperature higher than 300°C. The present invention will be described hereunder in consideration of the essential requirement; i.e., a higher pressing temperature.

In claim 1 of the present invention, there is provided an electrodeposited copper foil with carrier comprising a carrier foil, an organic adhesive interface layer formed on one surface of the carrier foil, and an electrodeposited copper layer serving as a copper foil deposited on the adhesive interface layer, wherein the organic adhesive interface layer is formed by use of thiocyanuric acid.

As shown in the schematic cross-sectional view of Fig. 1, the electrodeposited copper foil with carrier described in claim 1 comprises a carrier foil and an electrodeposited copper foil, as if one surface of one foil were bonded to one surface of the other foil. Throughout the present description, the terms "electrodeposited copper foil" and "electrodeposited copper foil layer" refer to the same portion, as is the case with "carrier foil" and "carrier foil layer"; and "adhesive interface" and "adhesive interface layer." The alternative expressions are appropriately employed depending on descriptions.

The electrodeposited copper foil with carrier according to the present invention comprises an adhesive interface formed of thiocyanuric acid between a carrier foil and an electrodeposited copper foil. The electrodeposited copper foil with carrier serves as a peelable foil in which the carrier foil can be peeled off stably by a considerably low peeling force, even though the copper foil with carrier has been subjected to press-forming at temperatures as high as over 300°C during production of copper-clad laminates.

Briefly, an adhesive interface layer formed of thiocyanuric acid provides a carrier-peel strength of a manually peelable level, even after press-forming is carried out at temperatures as high as over 300°C during production of copper-clad laminates. Peeling failure and remaining of carrier foil fragments on a copper-clad laqminates after peeling, which are observed when a conventional metallic adhesive interface layer is employed, are completely prevented. Furthermore, such features cannot be attained by employment of an adhesive interface layer formed of another organic compound such as benzotriazole or carboxybenzotriazole, which provides sufficiently stable peelability at 300°C or lower temperatures.

When the adhesive interface is formed of thiocyanuric acid, mutual diffusion between a carrier foil and an electrodeposited copper foil is effectively prevented during press-forming, even at temperatures higher than 300°. The adhesive interface layer does not increase bonding strength between two foils by heat, and serves as a barrier layer against mutual diffusion between two foils. Although the bonding strength increases slightly during production of electrodeposited copper foils with carrier, the peel strength can be maintained at a level which permits use as a electrodeposited copper foil with peelable carrier until completion of press-formation.

Thus, for an illustration purpose only, an adhesive interface layer was formed by use of thiocyanuric acid on a carrier foil of a thickness of 35 µₘ, and an electrodeposited copper foil layer of a thickness of 9 µₘ on the adhesive interface, so as to prepare a sample. The peel strength of the sample is 5.0 gf/cm before heating and 9.2 gf/cm after heating at 300°C for one hour. Although the peel strength increases, the manually peelable feature which is required for peelable foils is still maintained.

Next will be described the methods for forming an adhesive interface layer on a carrier foil by use of the aforementioned thiocyanuric acid. Specifically, the adhesive interface layer may be produced by dissolving the aforementioned thiocyanuric acid in a solvent, and immersing a carrier foil in the solution or applying the solution to a surface on which an adhesive layer is to be formed, through methods such as showering, spraying, dropping, and electrodeposition. The method for forming the interface layer is not particularly limited. The concentration of thiocyanuric acid in the solvent is preferably 0.01 g/l to 10 g/l, and the solution temperature is preferably 20-60°C. The concentration of thiocyanuric acid is not particularly limited, and a solution of high or low concentration can be employed without raising any particular problem.

As described in claim 5, in order to form the adhesive interface layer by use of thiocyanuric acid, the aforementioned method for applying thiocyanuric acid may be repeated, whereby the thickness of the adhesive interface layer is regulated with higher precision.

The thiocyanuric acid agent is considered to be formed firmly on a surface of the carrier foil in accordance with a possible mechanism of formation of the adhesive interface layer. For example, when an adhesive interface layer of thiocyanuric acid is formed on a carrier metal foil, the thiocyanuric acid agent is adsorbed onto the metal oxide layer formed on the carrier foil and forms chemical bonds with oxygen species contained in the metal oxide layer, thereby stabilizing thiocyanuric acid forming the organic adhesive layer. Therefore, the higher the concentration of thiocyanuric acid, the higher the rate of adsorption of thiocyanuric acid to the carrier foil. Principally, the concentration of thiocyanuric acid is determined in accordance with the speed of the production line. The time of contact between the carrier foil and the solution containing thiocyanuric acid is also determined by the speed of the production line, and in practice is generally 5-60 seconds.

In consideration of the aforementioned conditions, when the concentration is below the lower limit; i.e., 0.01 g/l, complete adsorption of thiocyanuric acid within a short period of time is difficult to attain and the thickness of the formed adhesive interface layer varies, resulting in failure to maintain the quality of the final product. When the concentration is in excess of the upper limit; i.e., 10 g/l, the adsorption rate does not increase in proportion to the amount of added thiocyanuric acid. Such an excessive concentration is disadvantageous from the viewpoint of production costs.

When the aforementioned thiocyanuric acid is used, the amount thereof for forming an organic adhesive interface layer is readily controlled and peel strength between a carrier foil and an electrodeposited copper foil can be adjusted to within an appropriate range. In addition, the formed adhesive interface layer has excellent thermal stability, and an appropriate peel strength can be assured after press-forming.

After a carrier foil is peeled off from an electrodeposited copper foil, thiocyanuric acid is transferred onto the surface of the electrodeposited copper foil, forming thiocyanuric acid coating film, which serves as an anti-corrosion layer of the copper foil. The thiocyanuric acid film can be readily removed by washing with an acidic solution such as diluted free sulfuric acid or diluted hydrochloric acid, and does not affect the production steps of printed wiring boards.

From another important point of view, at present, the aforementioned thiocyanuric acid has been proven to have no adverse effect on the production steps of printed wiring boards, such as a variety of resist application steps, etching steps, plating steps, and mounting steps, which are carried out after production of a copper-clad laminate.

Thiocyanuric acid, which itself is an organic compound, serves as a material having an electrically insulating property rather than electric conductivity. As mentioned above, the electrodeposited copper foil with carrier according to claim 1 is produced by cathodically polarizing a carrier foil *per se* to thereby form on the carrier foil an organic adhesive interface layer comprising thiocyanuric acid and electrodepositing copper directly on the thiocyanuric acid adhesive interface layer. Therefore, the adhesive interface layer must permit conduction of electricity. Thus, the thickness of the adhesive interface layer formed of thiocyanuric acid has a limitation, and must be adjusted to a thickness which ensures appropriate peel strength and which attains stable electrodeposition of copper.

In this case, concentration and treatment time of a thiocyanuric acid solution employed in forming an adhesive interface layer are rather insignificant, but the thickness of the thus-formed adhesive interface layer is important. In other words, the amount of thiocyanuric acid constituting the adhesive interface layer is important. Thus, according to claim 6, the adhesive layer preferably has a thickness of 1 nm to 1 µm.

When the thickness falls within the aforementioned range, appropriate peel strength can be assured even after press-forming at high temperature, and electrodeposition of copper can be performed stably. Specifically, when the amount of thiocyanuric acid used to form an organic adhesive interface layer (thickness) is below the lower limit; i.e., 1 nm, the thickness of the adhesive interface layer varies, and the adhesive layer encounters difficulty in providing a homogeneous organic adhesive interface layer. As a result, appropriate peel strength cannot be attained after press-forming, and in some cases portions of a carrier foil cannot be peeled off.

In contrast, when the thickness is in excess of the upper limit; i.e., 1 µm, electric current flowing in the carrier foil in the course of electrodeposition of copper becomes unstable. Thus, an electrodeposited copper foil layer of uniform thickness is difficult to form. Even though copper is deposited over a long period of time, peel strength required for completing press-forming safely is not attained. When the thickness of the adhesive interface layer increases further, conduction of electricity is never attained.

Since the adhesive interface layer has a thickness as thin as some nm to some µₘ, the thickness is measured by means of a transmission electron microscope (TEM). The analytical method is described with reference to Fig. 2. The electrodeposited copper foil with carrier according to the present invention is cut along line A-A' as shown in Fig. 2(a), to thereby prepare fragments. As shown in Fig. 2(b), gallium ions are simultaneously sputtered in the directions represented by arrows B and B', thereby thinning a portion such that the thickness permits observation under a TEM. Thus, in portion C, the adhesive interface layer sandwiched by the electrodeposited copper foil layer and the carrier foil layer can be observed directly.

The portion C was observed under a TEM, and the thickness of the adhesive interface layer was obtained through measurement by use of a photographic image thereof. Fig. 3 shows a photographic image of the portion C. In Fig. 3, the thickness of the adhesive interface layer varies from approximately 7 to 25 nm. On the basis of results of TEM observation, the practical thickness of the adhesive interface layer of an electrodeposited copper foil with carrier having an appropriate peel strength has proven to be 1 nm to 1 µm.

In the present description, the term "appropriate peel strength" refers to a peel strength, as measured on the basis of JIS C-6481, of 1-200 gf/cm. The range is calculated in consideration of electrodeposited copper foils with peelable carrier which have conventionally been used. Specifically, the range has been obtained in view of peel strength which has empirically been considered to be appropriate and ideal peel strength which users desire to attain. The lower the peel strength at an interface between a carrier foil and an electrodeposited copper foil, the easier the peeling of the carrier foil from the copper foil.

However, when the peel strength is less than 1 gf/cm, a carrier foil is spontaneously peeled partially from an electrodeposited copper foil during transport of a roll in the production process of the copper foil with carrier or during production of copper-clad laminates, thereby causing generation of failures such as blisters and slippage. When the peel strength is in excess of 200 gf/cm, a carrier foil is difficult to peel off, and peeling the carrier foil off requires a particular peeling apparatus. This situation differs from that made possible by the features of the present invention.

Alternatively, the thickness of an adhesive interface layer may be measured through a method such as quantitative analysis, measurement of surface resistance, or measurement of polarization potential.

In quantitative analysis, thiocyanuric acid contained in an adhesive interface is dissolved in a solvent, and the resultant solution is quantitatively analyzed by means of liquid chromatography. When the adhesive interface layer formed of thiocyanuric acid has a thickness of 1 nm to 20 nm, the layer contains thiocyanuric acid in an amount of 1-100 mg/m², as obtained through quantitative analysis.

Surface resistance is measured by means of a resistance meter (HIRESTER, product of Dia Instruments). Specifically, a cut piece of an electrodeposited copper foil with carrier is placed on a Teflon plate such that the copper foil side contacts the Teflon substrate, and a voltage of 10 V is applied to the foil. Although surface resistance varies depending on the type of carrier foil, the appropriate surface resistance is less than 10⁵ Ω when an electrodeposited copper foil with carrier is produced by forming an electrodeposited copper foil having a thickness of 9 µₘ on a copper carrier foil having a thickness of 18 µₘ.

When polarization potential measured by use of a solution containing free sulfuric acid (70 g/l) and copper sulfate (250 g/l) at a solution temperature of 40°C and a current density of 5 A/dm² (vs. Ag/AgCl as a reference electrode) is less negative than -100 mV, formation of an appropriate thiocyanuric acid adhesive interface layer has been proven.

No particular limitation is imposed on the material of the carrier foil which can be employed in the present invention, and examples of the material include aluminum, copper, and metal-coated resin film. In addition, the thickness of the carrier foil is not particularly limited. From an industrial point of view, materials having a thickness of 200 µm or less are generally called foils, and any materials may be employed so long as they can be called foils.

The electrodeposited copper foil which is to be placed on a carrier foil may be an ultra-thin copper foil having a thickness of 12 µm or less, or a copper foil having a thickness of more than 12 µm. Conventional electrodeposited copper foils with carrier are employed so as to provide ultra-thin copper foils. Thus, electrodeposited copper foils with carrier containing an electrodeposited copper foil layer having a thickness of more than 12 µm, which foils may be included in the present invention, have not been supplied commercially. Electrodeposited copper foils with such thick carriers can be prepared, since an adhesive interface layer formed of thiocyanuric acid provides appropriately easy peelability even after press-forming at high temperature. In addition, as described below, new use of the electrodeposited copper foils with carrier can be provided.

In practical application of the copper foil with carrier, typically, copper microparticles are uniformly deposited on the outer surface of the electrodeposited copper foil involved in the electrodeposited copper foil with carrier as described in claim 1 for preparing copper-clad laminates and printed wiring boards, except for particular use. The copper microparticles are similar to those formed on a conventional electrodeposited copper foil onto which a resin substrate is bonded. The microparticles provide an anchor effect to the bonded substrate, to thereby prevent the electrodeposited copper foil from readily peeling off.

In claim 2 of the present invention, there is provided an electrodeposited copper foil with carrier comprising a carrier foil, an adhesive interface layer formed by use of thiocyanuric acid on both surfaces of the carrier foil, and an electrodeposited copper layer serving as a copper foil deposited on each surface of the adhesive interface layer. As shown in Fig. 4, which is a schematic cross-sectional view, the electrodeposited copper foil with carrier described in claim 2 has a structure in which an electrodeposited copper foil is as if bonded to each surface of a carrier foil, whereas the electrodeposited copper foil with carrier described in claim 1 has a structure in which an electrodeposited copper foil is bonded to one surface of a carrier foil.

By use of the electrodeposited copper foil with carrier as described in claim 2, use of press plates may be omitted during production of copper-clad laminates, and migration of impurities into a shiny side of a copper foil during press-forming is completely prevented. A typical method for producing a double-sided copper-clad laminate is shown in Fig. 5. As shown in Fig. 5, a unit comprising a press plate which is obtained by mirror-finishing a sheet of a heat-resistant material such as stainless steel; a copper foil; one or a plurality of prepregs; a copper foil; and a press plate are repeatedly laminated (laid-up) between two pressing plates. Subsequently, the laid-up units are pressed by means of the pressing plates heated to high temperature, to thereby melt a resin component of the prepregs. Thus, the copper foil and the prepregs are press-bonded.

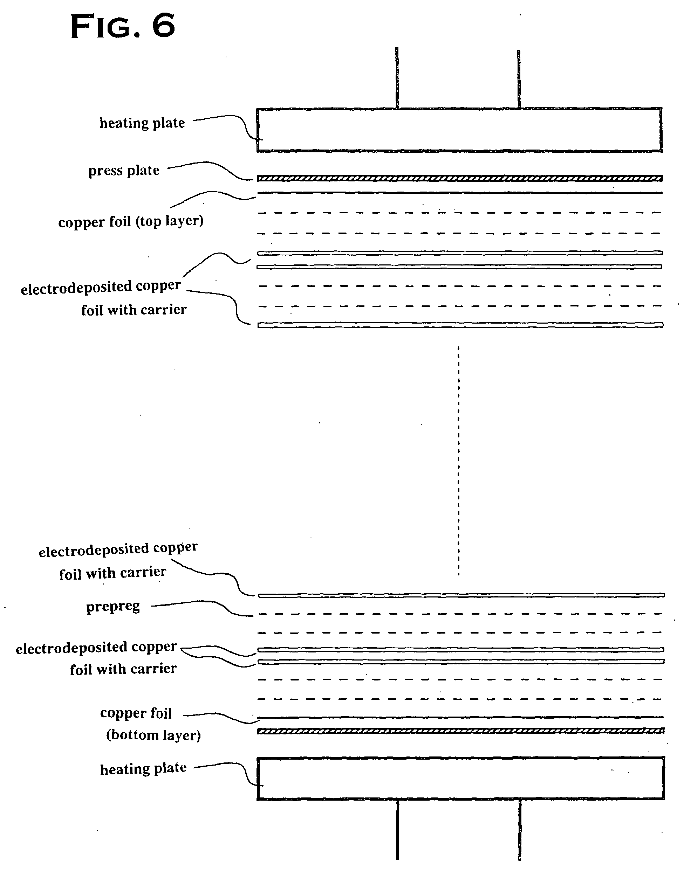

When the electrodeposited copper foil with carrier described in claim 2 is employed, press plates other than the uppermost and lowermost ones may be omitted. Specifically, as shown in Fig. 6, a conventional electrodeposited copper foil or the electrodeposited copper foil with carrier described in claim 1 is employed as the uppermost or lowermost layer of the laid-up units, and the electrodeposited copper foils with carrier described in claim 2 are employed as internal layers other than the two layers. After press-forming is completed, each unit can be separated by peeling from a carrier foil.

The thickness corresponding to the omitted press plates increases the number of units which comprise a copper foil and a prepreg and can be placed within the daylight between two heating plates, and the number of copper-clad laminates produced per press operation can be increased. In addition, thermal conduction through the laid-up units increases, thereby enhancing productivity. Typically, the thickness of an employed press plate is 0.8-3.0 mm, that of a copper foil 3-50 µm, and that of a prepreg 30-180 µm. In consideration of thickness conditions, productivity of copper-clad laminates may be remarkably inreased.

In claim 3 of the present invention, there is provided an electrodeposited copper foil with carrier comprising a carrier foil, an adhesive interface layer formed by use of thiocyanuric acid on one surface of the carrier foil, and copper microparticles alone electrodeposited on the adhesive interface layer, the deposited copper microparticles serving as an electrodeposited copper foil.

In claim 4 of the present invention, there is provided an electrodeposited copper foil with carrier comprising a carrier foil, an adhesive interface layer formed by use of thiocyanuric acid on each surface of the carrier foil, and copper microparticles alone electrodeposited on each adhesive interface layer, the deposited copper microparticles serving as an electrodeposited copper foil.

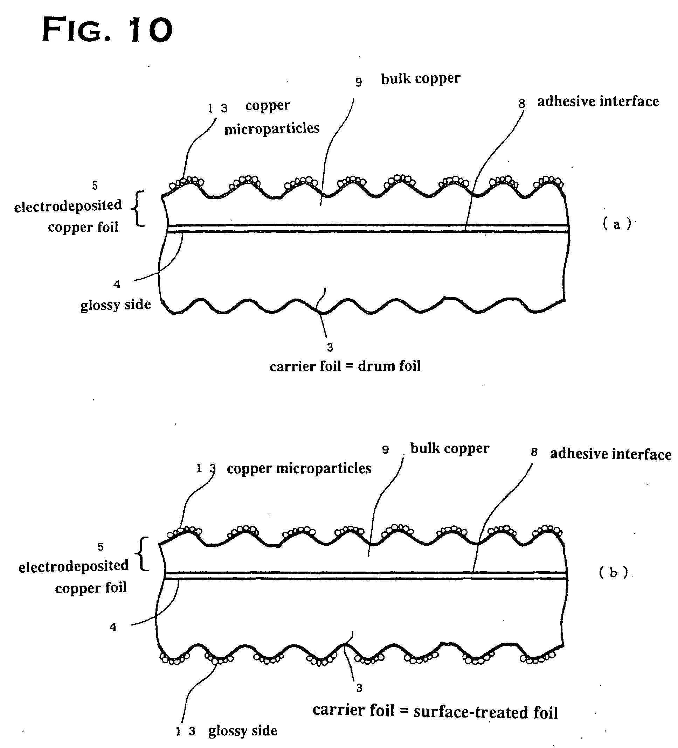

Fig. 7 is a cross-sectional view of a typical electrodeposited copper foil. As shown in Fig. 7, the copper foil comprises a bulk copper foil assuring electrical conductivity; copper microparticles serving as a surface treatment layer assuring adhesion stability to an insulating substrate; and an anti-corrosion layer. In electrodeposited copper foils with carrier according to claims 3 and 4, a bulk copper layer serving as a conductive layer of the electrodeposited copper foil as described in claim 1 or 2 is removed. As shown in Figs. 8 and 9, only copper microparticles are deposited on each adhesive interface layer formed of thiocyanuric acid. These electrodeposited copper foils with carrier may be used in a manner similar to that employed for the electrodeposited copper foils with carrier described in claims 1 and 2. When copper-clad laminates are produced, a prepreg is bonded exclusively to copper microparticles.

In the process of production of printed wiring boards, a wiring-board maker removes a carrier foil and can form a bulk layer of a predetermined thickness through an arbitrary plating method in accordance with the timing of the purpose. For example, such an electrodeposited copper foil with carrier in which the electrodeposited copper foil is formed exclusively of copper microparticles is transformed into a copper-clad laminate, and a bulk copper layer can be formed on copper microparticles through a panel plating method after a carrier foil is removed. In the method, the thickness of the bulk copper layer can be adjusted in accordance with the type of circuits to be formed, and etching can be carried out appropriately in accordance with a target pitch of wirings in the circuits. Accordingly, the finer a target circuit, the more effective such a method for producing printed wiring boards. Thus, high-density printed wiring boards can be readily fabricated.

Electrodeposited copper foils with carrier according to claims 7 to 10 of the present invention will next be described. In all cases, an electrodeposited copper foil is employed as the carrier. For the sake of understanding of description, a conventional electrodeposited copper foil process serving as a carrier foil will be described briefly.

In general, electrodeposited copper foils produced through an electrofforming step and a surface treatment step are employed as a base material for fabricating printed wiring boards used in the electric and electronic industries.

An apparatus for producing an electrodeposited copper foil; more precisely, a bulk layer of the electrodeposited copper foil, comprises a rotating drum cathode, and lead anodes facing each other and at least partially surrounding the drum cathode, and a cell contains a cupric sulfate solution. During electrolysis, copper is electrodeposited on the rotating drum cathode, to thereby form copper foil through peeling from the rotating drum cathode. The thus-obtained copper foil is hereinafter referred to as a "drum foil." Since the drum foil has not been subjected to any surface treatment such as anti-corrosion treatment, the foil having a highly activated surface readily undergoes oxidation by oxygen contained in the air.

The drum foil surface which is peeled from the cathode is glossy and smooth, since a mirror-polished surface of the rotating cathode is transferred to the foil surface. The thus-obtained surface is called the shiny side. In contrast, the surface configuration of the other surface, on which copper is electrodeposited, is rough, since the growth rate of copper varies depending on the deposited crystal plane. Thus, this surface is called the matte side. The matte surface serves as a surface onto which an insulating material is bonded during production of a copper-clad laminate. Throughout the present description, the term "matte side" is employed for describing a rough surface of the drum foil.

Subsequently, the matte side of a drum foil is subjected to surface treatment; i.e., nodular treatment and anticorrosion treatment. The nodular treatment on the matte side is carried out through electrolysis in a copper sulfate solution under burnt deposit conditions, thereby depositing copper microparticles on the matte side so as to form a rough surface. Immediately after completion of burnt deposition, seal plating is carried out under smooth plating conditions, so as to prevent release of deposited copper microparticles. Thus, the matte side coated with electrodeposited copper microparticles is called a "nodular-treated side." The term "nodular-treated side" is also employed in the present description to refer to a copper-microparticle-deposited side of an electrodeposited copper foil with carrier.

Next, anti-corrosion treatment is carried out on both sides of the copper foil through plating with zinc, zinc alloy, or chromium, and the thus-treated foil is dried and wound into a roll, thereby providing an electrodeposited copper foil as a target product. The thus-treated foil is generally called a "surface-treated foil." In the present invention, although the aforementioned drum foil itself is generally employed as a carrier foil, the surface-treated foil may also be employed. Hereinafter, electrodeposited copper foils with carrier described in claims 7 to 10 will be described.

Several cross-sectional views of electrodeposited copper foils with carrier and a typical electrodeposited copper foil are shown in Figs. in the description. In these cross-sectional views, a view of an anti-corrosion layer is omitted. However, an anti-corrosion layer is typically provided for preventing oxidation of a copper foil by contact with air, and serves as an outermost layer after surface-treatment is completed. In the case of an electrodeposited copper foil with carrier, at least one anti-corrosion-treated layer serves as an outermost layer of nodular-treated electrodeposited copper foil.

In claim 7 of the present invention, there is provided an electrodeposited copper foil with carrier as described in any one of claims 1 to 6, wherein an electrodeposited copper foil having a thickness of 12 µm to 210 µm is employed. Claim 7 is based on the observation that use of an electrodeposited copper foil as a carrier foil provides a variety of advantageous effects which conventional electrodeposited copper foils with carrier have not provided.

The following effects are considered to be advantages in use of an electrodeposited copper foil as a carrier foil. Firstly, when a carrier foil which is obtained through rolling; e.g., rolled aluminum material, is employed, the carrier foil must be stained with rolling oil or is coated with an oily material so as to prevent oxidation. The oily material affixed on the foil, which affects deposition of copper on the carrier foil, must be removed in a certain step. An electrodeposited copper foil, which is produced without use of oil, is not inevitably stained with oil, and possibly formed oxide film can be readily removed through pickling, thereby reducing the number of steps and facilitating control of the steps.

In addition, when an electrodeposited copper foil is employed as a carrier foil, both the carrier foil and the copper foil onto which the carrier foil is bonded are formed of copper and have identical physical properties. Thus, both foils can be etched with a common etchant. In one application, an etching resist layer is formed on a carrier foil of a copper-clad laminate obtained from the electrodeposited copper foil with carrier and a printed circuit is formed by etching without peeling off the carrier foil. The carrier foil may be peeled off after completion of formation of the circuit. In this manner, the surface of a circuit formed from a copper foil is prevented from staining and affixing impurities, and reliability in post operation such as plating can be remarkably improved.

Furthermore, the electrodeposited copper foil serving as a carrier foil has a purity of 99.99% or more. In addition, the electrodeposited copper foil with carrier according to the present invention contains no metallic element other than copper in the adhesive interface therein. Thus, peeled-off carrier foils can be recycled and do not generate unnecessary industrial waste. The carrier is advantageous in view of environmental protection. For example, peeled-off carrier foils are collected and remelted to form copper ingots. Alternatively, the carrier foils may be dissolved into free sulfuric acid, to thereby prepare a copper sulfate solution that is to serve as a source of electrodeposited copper foils.

The thickness of the electrodeposited copper foil serving as a carrier foil is in the range of 12 µm to 210 µm. In order to prevent wrinkle generation in an ultra-thin copper foil having a thickness of 9 µm or less and serving as a material for supporting the thin copper foil, the electrodeposited copper foil has a thickness of at least approximately 12 µm. When the electrodeposited copper foil has a thickness greater than 210 µm, the foil is almost a copper plate, which is difficult to wind into a roll.

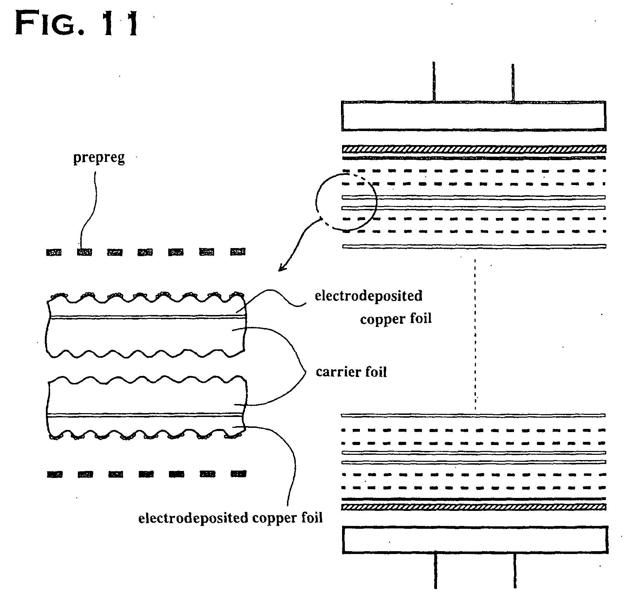

In claim 8 of the present invention, there is provided an electrodeposited copper foil with carrier, wherein an adhesive interface layer is formed on a shiny side of an electrodeposited copper foil serving as a carrier foil, by use of thiocyanuric acid and an electrodeposited copper foil layer is deposited on the adhesive interface layer. The cross-sectional view of the electrodeposited copper foil with carrier is shown in Fig. 10. In the electrodeposited copper foil with carrier, two electrodeposited copper foils are bonded together via an adhesive interface layer such that one shiny side of a typical electrodeposited copper foil faces the other shiny side. In claims 7 to 10, the electrodeposited copper foil encompasses both a copper foil layer comprising a typical bulk copper layer and a copper-microparticle layer, and a copper foil layer comprising only a copper-microparticle layer.

In this case, either a drum foil or a surface-treated foil may be employed as an electrodeposited copper carrier foil. In fact, there is no difference in roughness between the shiny sides of these two types of foils. Fig. 10(a) shows a schematic cross-sectional view of the electrodeposited copper foil with carrier in which a drum foil is employed as a carrier foil, and Fig. 10(b) shows a schematic cross-sectional view of the electrodeposited copper foil with carrier in which a surface-treated foil is employed as a carrier foil. Selection of the carrier foil in the electrodeposited copper foil with carrier; i.e., a drum foil or a surface-treated foil, determines the mode to employ for producing copper-clad laminates.

Possible modes for employing the electrodeposited copper foils with carrier for producing copper-clad laminates in both cases will be described. Firstly, a method for producing copper-clad laminates by employing a drum foil as a carrier foil will be described. The schematic cross-sectional view of the electrodeposited copper foil with carrier is shown in Fig. 10(a). As is clear from Fig. 10(a), the surface of the foil on which copper microparticles are deposited during surface treatment can be bonded to a prepreg.

Thus, a copper-clad laminate can be produced by laying-up the electrodeposited copper foil with carrier, a prepreg (a prepreg and an internal substrate when forming an outer copper layer of a multilayer substrate), and press plates as shown in Fig. 5 and press-forming in a manner similar to that employed when a conventional copper foil is used. By use of the electrodeposited copper foil with carrier, press-forming may be carried out without use of internal press plates, as shown in Fig. 11. Specifically, press plates are disposed at the top and the bottom layers, each of which directly contacts heating plates, and the electrodeposited copper foils with carrier and prepregs disposed between the two press plates are laid-up.

Each of the top layer and the bottom layer of the laid-up layers is the electrodeposited copper foil with carrier. As shown in the enlarged view in Fig. 11, two electrodeposited copper foils with carrier are bonded to each other such that the carrier foils are directly bonded to each other and each nodular-treated electrodeposited copper foil contacts a prepreg. After press-forming is completed, a carrier foil is peeled off from an adhesive interface, thereby forming an outer copper foil of a double-sided substrate or a multilayer substrate.

Secondly, a method for producing copper-clad laminates by employing a surface-treated copper foil as a carrier foil will be described. The cross-sectional view of the electrodeposited copper foil with carrier is shown in Fig. 10(b). As is clear from Fig. 10(b), the surface of the foil on which copper microparticles are deposited during surface treatment can be bonded to a prepreg. In this case, both surfaces; i.e., the electrodeposited copper foil side and the carrier foil side, serve as the above surface.

Briefly, the electrodeposited copper foil with carrier is prepared by bonding two typical surface-treated electrodeposited copper foils such that the shiny sides are brought into contact with each other. Thus, the carrier foil may also serve as an electrodeposited copper foil of a copper-clad laminate. Such a structure provides the following mode of use.

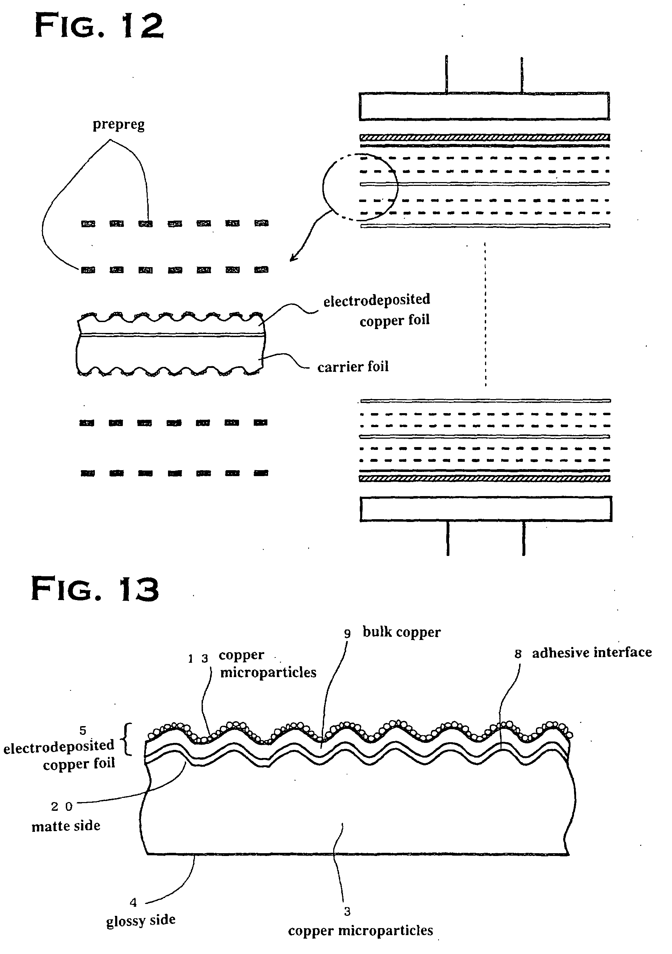

Thus, a copper-clad laminate can be produced by laying-up the electrodeposited copper foil with carrier, a prepreg (a prepreg and an internal substrate when forming an outer copper layer of a multilayer substrate), and press plates as shown in Fig. 12 and press-forming. By use of the electrodeposited copper foil with carrier, press-forming may be carried out without use of internal press plates, as shown in Fig. 12. Specifically, press plates are disposed at the top and the bottom layers, each of which directly contacts heating plates, and the electrodeposited copper foils with carrier and prepregs disposed between the two press plates are laid-up.

Each of the top layer and the bottom layer of the laid-up layers is the electrodeposited copper foil with carrier or a conventional copper foil. As shown in the enlarged view in Fig. 12, each surface of the electrodeposited copper foils with carrier placed as internal layers is brought into contact with a prepreg. Press-forming can be carried out without employing internal press plates. After press-forming is completed, a carrier foil is peeled off from an adhesive interface, thereby forming an outer copper foil of a double-sided substrate or a multilayer substrate. The mode is also advantageous in that no scrap is produced.

As described above, the mode for employing the electrodeposited copper foil with carrier according to the present invention; i.e., a method for press-forming, can be attained by maintaining low the peel strength of electrodeposited copper foil with carrier at the adhesive interface layer and stabilizing peelability. Accordingly, advantages of the electrodeposited copper foil with carrier according to the present invention provide a great effect to the printed wiring board industry and great contribution to reduction of costs for producing copper-clad laminates.

When the electrodeposited copper foil layer deposited on an electrodeposited foil serving as a carrier foil is formed into a ultra-thin layer, etching of the copper foil layer can be completed in a short period of time so as to form a circuit having wiring pitches of approximately 50 µm by use of a copper-clad laminate wearing the ultra-thin copper foil. Thus, a microcircuit of a favorable aspect ratio can be formed.

In claim 9 of the present invention, there is provided an electrodeposited copper foil with carrier, wherein an adhesive interface layer is formed on a matte side of an electrodeposited copper foil serving as a carrier foil, by use of thiocyanuric acid, and an electrodeposited copper foil layer is deposited on the adhesive interface layer. The carrier foil employed herein is typically the aforementioned drum foil and is rarely a surface-treated foil, since copper microparticles are deposited on the matte side of the surface-treated foil.

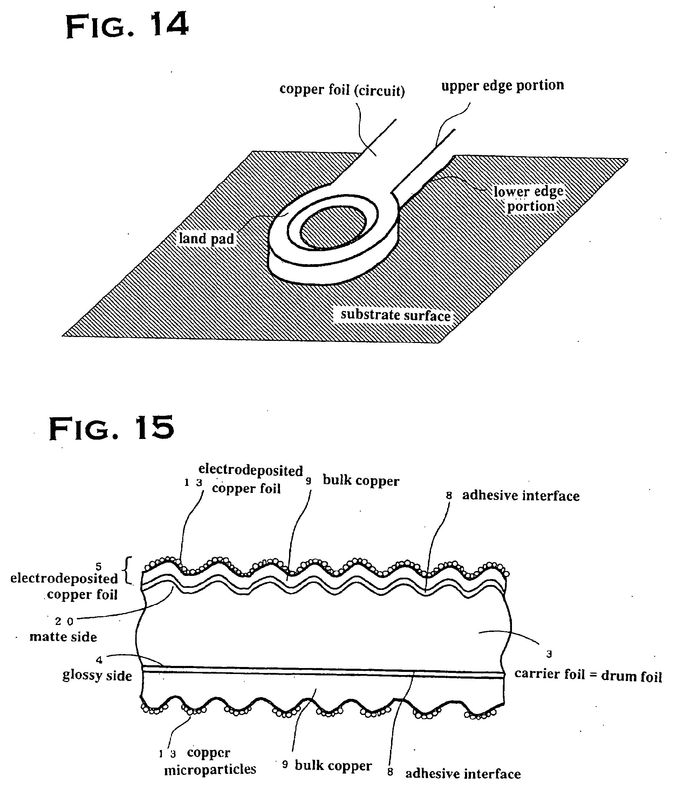

The schematic cross-sectional view of the electrodeposited copper foil with carrier according to claim 9 is shown in Fig. 13. As is clear from Fig. 13, the ultra-thin electrodeposited copper foil layer is formed on the matte side of an electrodeposited copper foil serving as a carrier foil such that the rough profile of the matte side is transferred. In other words, the electrodeposited copper foil layer assumes a wavy form. Thus, when a copper-clad laminate is produced by use of the copper foil, the wavy form is transferred in a press-formed product. The shape is very advantageous for forming a microcircuit. Modes for employing the electrodeposited copper foils with carrier for producing copper-clad laminates are similar to those described in claim 8; therefore, repeated description will be omitted.

Physical properties which are required for forming a microcircuit will be summarized briefly to the following four points: (1) assurance of favorable adhesion to an etching resist; (2) assurance of favorable exposure conditions; (3) short etching time; and (4) appropriate peel strength (including resistance to chemicals). The electrodeposited copper foils with carrier satisfy most of the aforementioned properties. Among these foils, the electrodeposited copper foil assuming a wavy form predominantly assures favorable adhesion to etching resist and exposure conditions.

Employment of such an electrodeposited copper foil assuming a wavy form in a copper-clad laminate enhances adhesion between a resist and the surface of an electrodeposited copper. More specifically, when the adhesion to an etching resist is enhanced, undermining of an etchant into an adhesive interface between a copper foil and an etching resist can be prevented, thereby forming a circuit exhibiting a cross-section of a favorable aspect ratio. Thus, impedance-controlled microcircuits are readily formed. In addition, the surface of the electrodeposited copper assumes a matte-like surface rather than a typical flat shiny side, due to its wavy shape. Thus, excessive scattering of exposure light in an etching resist for forming a pattern can be prevented, and exposure broadening in pattern edge portions is mitigated.

When an copper-clad laminate employing an electrodeposited copper foil assuming a wavy form is plated, peel strength between the copper foil and the plate layer has proven to increase. Thus, the electrodeposited copper foil with carrier enhances adhesion of a plate layer. Furthermore, the peel strength between the electrodeposited copper foil of claim 9 and an FR-4 substrate increases by approximately 3 gf/cm as compared with the copper foil of claim 8.

As a result, there can be prevented the deterioration in aspect ratio of a cross-section of circuit that is caused during formation of 50 µm-pitch microcircuits by use of a conventional electrodeposited copper foil, and an ideal aspect ratio can be attained. In addition, since exposure broadening in an etching resist is suppressed, edge portions of the formed circuit are sharp. Thus, microcircuits are readily formed.

Sharp edge portions of the circuit are shown in Fig. 14. In Fig. 14, the linearity of both upper edge portion and the lower edge portion are straight, and whole edge portions of circular circuit portions such as a land pad employed for mounting parts to fabricate printed wiring boards are smooth. When a straight circuit is formed with uniformity, migration of copper when the fabricated printed wiring boards are operated can be prevented, and electrons discharged from tips of edge portions when high-frequency signals are applied can be suppressed.

In claim 10 of the present invention, there is provided an electrodeposited copper foil with carrier, wherein an adhesive interface layer is formed on both a shiny side and a matte side of an electrodeposited copper foil serving as a carrier foil, by use of thiocyanuric acid, and an electrodeposited copper foil layer is deposited on each adhesive interface layer. Thus, the copper foil of claim 10 has characteristics of the copper foil of claim 8 and that of claim 9.

Similar to the copper foil of claim 9, the carrier foil employed herein is the aforementioned drum foil, since copper must be electrodeposited on the matte side of the carrier foil. As is clear from a schematic cross-sectional view of Fig. 15, an electrodeposited copper foil serving as a carrier foil is sandwiched by outer electrodeposited copper foils.

The copper foil as described in claim 10 having such a structure can be press-formed through a method as shown in Fig. 12, the method being one of the aforementioned methods for producing a copper-clad laminate by use of the electrodeposited copper foil with carrier as described in claim 7. The aforementioned second method for producing a copper-clad laminate can be applied. The mode for employing the electrodeposited copper foil is substantially identical with the aforementioned mode.

In this method, the electrodeposited copper foil with carrier as described in claim 11 is employed instead of that described in claim 8. Thus, a copper-clad laminate can be produced by laying-up the electrodeposited copper foil with carrier, a prepreg (a prepreg and an internal substrate when forming an outer copper layer of a multilayer substrate), and press plates, and press-forming. By use of the electrodeposited copper foil with carrier, press-forming may be carried out without use of internal press plates, as shown in Fig. 12. Specifically, as shown in Fig. 12, press plates are disposed at the top and the bottom layers, each of which directly contacts heating plates, and the electrodeposited copper foils with carrier and prepregs disposed between the two press plates are alternately laid-up.

Each of the top layer and the bottom layer of the laid-up layers is the electrodeposited copper foil with carrier or a conventional copper foil. One electrodeposited copper foil with carrier according to claim 10 is disposed as an internal layer of the laid-up product and alternately laminated with prepregs. Thus, press-forming can be carried out without employing internal press plates. After press-forming is completed, a carrier foil is peeled off from an adhesive interface, thereby forming an outer copper foil of a double-sided substrate or a multilayer substrate.

As described above, the mode for employing the electrodeposited copper foil with carrier according to the present invention can be attained by maintaining low the peel strength of electrodeposited copper foil with carrier at the adhesive interface layer and stabilizing peelability.

A method described in claim 11 is preferably employed for producing electrodeposited copper foils with carrier as described in the aforementioned claims 1 to 10. Since the carrier foil is typically rolled, the carrier foil is preferably treated continuously, in view of production yield thereof.

The present inventors have employed a method for producing an electrodeposited copper foil with carrier, which method comprises pulling a rolled carrier foil from one direction and passing the carrier foil in an apparatus wherein a variety of baths for forming an electrodeposited copper foil layer are continuously disposed in-line; i.e., a pickling bath, an adhesive-interface-forming bath containing thiocyanuric acid, a bath for forming a bulk copper layer to serve as an electrodeposited copper foil layer, a nodular-treatment bath for depositing copper microparticles on the bulk copper layer, an anti-corrosion-treatment bath, and a drying portion are disposed in-line with appropriately provided water-rinsing baths, to thereby continuously form a thiocyanuric acid adhesive interface layer and an electrodeposited copper layer on the carrier foil.

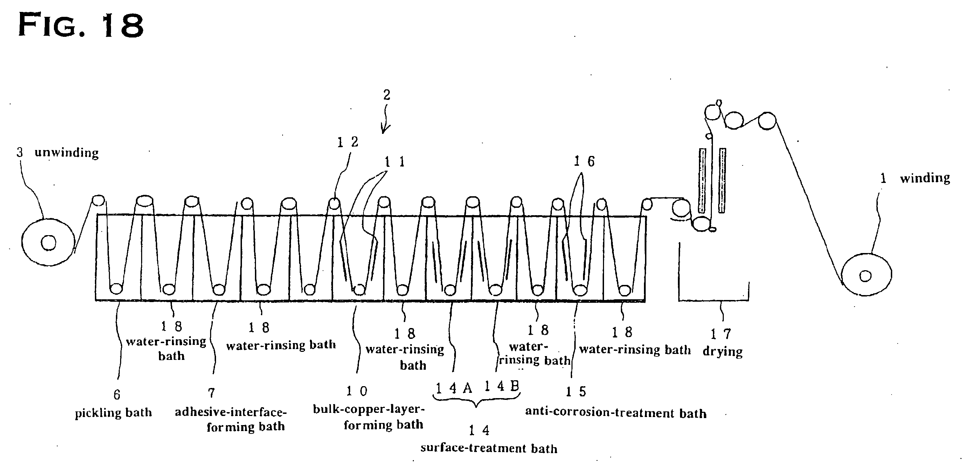

According to the present invention, in a first method, a carrier foil is unwound from a roll and travels, in a winding manner, in a bath for forming an electrodeposited copper foil layer and travels along the process line as shown in Fig. 16. The foil sequentially travels in an adhesive-interface-forming bath, a bath for forming a bulk copper layer serving as a copper foil layer, a nodular-treatment bath for depositing copper microparticles on the bulk copper layer, an anti-corrosion-treatment bath, and a drying portion. In a second method, an unwound carrier foil travels horizontally, in a floating manner, along the process line as shown in Fig. 17, where an adhesive interface layer, an electrodeposited copper layer, and a nodular-treated layer are sequentially formed.

Either method is employed, depending on the thickness of the carrier foil. In the first method, a carrier foil travels in a winding manner by means of tension rolls. The tension of a short portion of the carrier foil can readily be controlled, and wrinkle generation is readily prevented by controlling the tension. When wrinkles are generated in the carrier foil during traveling, the distance between the anode and the foil varies, thereby generating unevenness in electrodeposition. Thus, constant electrodeposition is not attained. In addition, in the first method, an electrodeposited copper foil layer can be formed on each side of the carrier foil as described in any one of claims 2, 4, and 11, by disposing anodes so as to sandwich the foil.

If formation of a bulk copper layer in a bulk-copper-layer-forming bath is omitted, an electrodeposited copper foil with carrier in which an electrodeposited copper foil is formed from copper microparticles can be readily produced. Similarly, such an electrodeposited copper foil is also produced through the second method, as described below.

The second method is employed exclusively for producing an electrodeposited copper foil with carrier in which an electrodeposited copper foil layer is formed on one side of the carrier foil. In the second method, within each bath a solution contained therein springs from space between elements such as anodes disposed in parallel and facing the carrier foil. Since the carrier foil travels on each springing solution in a floating manner, fluttering (up-down movement of the carrier foil) is caused during traveling, thereby generating unevenness in electrodeposition. In the second method, application of tension to the carrier foil is difficult as compared with the first method. Controlling of tension is more difficult when the foil is thinner. Therefore, the second method is preferably employed for handling a thick carrier foil.

Pickling is carried out in order to completely remove oily matter deposited on a surface of the carrier foil (degreasing) or to remove a surface oxide film coated on a metallic foil. The carrier foil is cleaned by passing in a pickling bath so as to attain uniform electrodeposition in a subsequent step. The acid solution employed for pickling is not particularly limited, and solutions such as hydrochloric acid solution, free sulfuric acid solution, and free sulfuric acid-hydrogen peroxide solution may be employed. The appropriate conditions, such as concentration of the solution and solution temperature, may be determined in accordance with characteristics of a production line. In addition, pickling is generally required for a drum foil which is to be employed as a carrier foil. In contrast, a surface-treated carrier foil containing corrosion-inhibiting elements on the surface does not require pickling.

An organic adhesive interface is formed on at least one surface of a carrier foil by use of a bath containing thiocyanuric acid. Several methods may be employed; i.e., (1) immersing a carrier foil in a bath filled with a solution containing thiocyanuric acid; (2) applying a thiocyanuric acid-containing solution to a surface on which an adhesive layer is to be formed, through showering or dropping in a cell; and (3) electrodepositing thiocyanuric acid in a bath.

After the organic adhesive interface layer is formed in the aforementioned manner, a bulk copper layer―electrodeposited copper foil―is formed on the organic adhesive interface layer. No particular limitation is imposed on the copper ion source employed in a bulk copper layer-forming bath, and a solution such as copper sulfate solution or copper pyrophosphate solution may be used. For example, a copper sulfate solution comprising copper (30-100 g/l) and free sulfuric acid (50-200 g/l) is employed at a solution temperature of 30-80°C and a current density of 1-100 A/dm², and a copper pyrophosphate solution comprising copper (10-50 g/l) and potassium pyrophosphate (100-700 g/l) is employed at a solution temperature of 30-60°C, a pH of 8-12, and a current density of 1-10 A/dm². In practice, an organic adhesive interface-formed carrier foil is immersed in a copper-source solution. The carrier foil *per se* is cathodically polarized, while anodes are placed so as to face an adhesive surface of the carrier foil in parallel. Thus, copper species for forming a bulk copper layer are homogeneously and smoothly deposited on the organic adhesive interface layer. The anode configuration is also employed in other baths in which electrolysis is carried out.

After formation of the bulk copper layer is completed, the carrier foil is treated in a copper-microparticles-forming bath so as to form copper microparticles on the bulk copper layer. More specifically, the process for forming copper microparticles includes a step of depositing copper microparticles on the bulk copper layer and a step of seal plating so as to prevent release of deposited copper microparticles.

In a step of depositing copper microparticles on the bulk copper layer, a solution similar to a solution placed in the aforementioned bulk-copper-foil-forming bath is used as a copper source. Bulk-copper-foil is formed under smooth plating conditions, whereas copper microparticles are deposited under burnt deposition conditions. Typically, a solution employed for depositing copper microparticles on the bulk copper layer has a concentration lower than that of a solution for forming a bulk copper layer, so as to readily attain burnt deposition conditions. No particular limitation is imposed on the burnt deposition conditions, and the conditions are determined in consideration of characteristics of a production line. For example, a copper sulfate solution comprising copper (5-20 g/l), free sulfuric acid (50-200 g/l), and an optional additive such as α-naphthoquinone, dextrin, glue, or thiourea is employed at a solution temperature of 15-40°C and a current density of 10-50 A/dm².

Seal plating is a step for uniformly coating copper microparticles with copper under smooth plating conditions so as to prevent release of deposited copper microparticles. Thus, a solution similar to that placed in the aforementioned bulk-copper-foil-forming bath is used as a copper source. No particular limitation is imposed on the uniform deposition conditions, and the conditions are determined in consideration of characteristics of a production line. For example, a copper sulfate solution comprising copper (50-80 g/l) and free sulfuric acid (50-150 g/l) is employed at a solution temperature of 40-50°C and a current density of 10-50 A/dm².

The anti-corrosion treatment prevents oxidation-induced corrosion of a surface of an electrodeposited copper foil layer so as to prevent failures in the course of producing copper-clad laminates and printed wiring boards. Both organic anti-corrosion treatment making use of a compound such as benzotriazole or imidazole and inorganic anti-corrosion treatment making use of a substance such as zinc, chromate, or zinc alloy may be acceptable. These methods may be selected in accordance with the purpose of employment of the electrodeposited copper foil with carrier. When an organic compound is employed in anti-corrosion, such an organic agent may be applied through immersion, showering, or electrodeposition.

When an inorganic compound is employed, a corrosion-inhibiting element may be deposited on an electrodeposited copper foil through electrolysis or substitution deposition. For example, a plating bath such as a zinc pyrophosphate plating bath, a zinc cyanide plating bath, or a zinc sulfate plating bath may be employed for carrying out anti-corrosion treatment by use of zinc. Specifically, a zinc pyrophosphate plating bath comprising zinc (5-30 g/l) and potassium pyrophosphate (50-500 g/l) is employed at a solution temperature of 20-50°C, a pH of 9-12, and a current density of 0.3-10 A/dm².

After the carrier foil is passed through the aforementioned bath containing a treatment solution, the thus-formed electrodeposited copper foil with carrier is dried in order to coil to a roll. Specifically, the thus-formed wet electrodeposited copper foil with carrier is passed through a heat-drying furnace.

The electrodeposited copper foils with carrier described in claims 1 to 10 are produced through the above steps. These electrodeposited copper foils predominantly serve as material for producing printed wiring boards. Thus, in claim 12, there is provided a copper-clad laminate or a printed wiring board produced by use of the electrodeposited copper foil with carrier as recited in any one of claims 1 to 10.

In the present specification, the terms "copper-clad laminate" and "printed wiring board" encompass a single-sided substrate, a double-sided substrate, and a multilayer substrate. Such substrates may be fabricated from a rigid substrate, a hybrid substrate, or a flexible substrate including a particularly designed substrate such as TAB or COB.

### Examples

Embodiments for carrying out the present invention will next be described. In the following examples, methods for producing the electrodeposited copper foil with carrier of the present invention and copper-clad laminates produced from the electrodeposited copper foil with carrier are described, along with results of evaluation of the foils. The carrier foil described in the following examples is formed of an electrodeposited copper foil. In the Figs., when possible, identical portions are denoted by the same reference numerals.

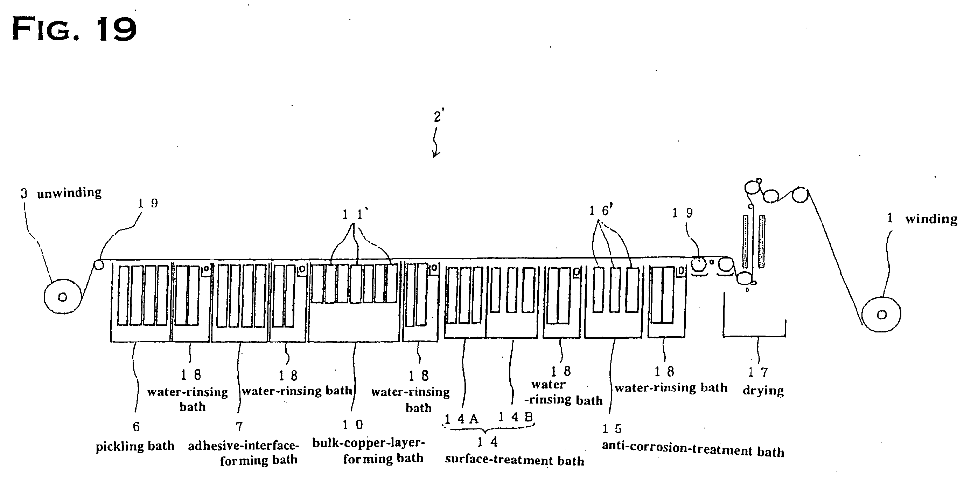

Example 1: In the present embodiment, an electrodeposited copper foil with carrier 1 according to claim 9, which is shown in Fig. 10(a), will be described. An apparatus 2 for producing an electrodeposited copper foil with carrier 1 is shown in Fig. 18. In the apparatus, a carrier foil 3 is unwound from a foil roll and travels, in a winding manner, along the process line to thereby produce an electrodeposited copper foil layer 5. A drum foil having a thickness of 18 µm and classified as grade 3 was employed as the carrier foil 3, and the electrodeposited copper foil layer 5 having a thickness of 5 µₘ was formed on a shiny side 4 of the carrier foil. Hereinafter, production conditions of electrodeposited copper foils with carrier will be described with reference to an apparatus wherein a variety of baths are continuously disposed in-line.

Firstly, the carrier foil 3 taken from the foil roll was transferred into a pickling bath 6 filled with a diluted free sulfuric acid solution having a concentration of 150 g/l, at 30°C. The carrier foil was immersed for 30 seconds, to remove oily matter and surface oxide film from the surface of the carrier foil 3.

After the carrier foil 3 had been treated in the pickling bath 6, the foil was transferred into an adhesive-interface-forming bath 7 filled with a 5 g/l aqueous solution of thiocyanuric acid (pH 5) and maintained at 40°C. The carrier foil 3 was run into the bath and immersed for 30 seconds, thereby forming on a surface of the carrier foil 3 an adhesive interface layer 8.

After the adhesive interface layer 8 had been formed, a bulk copper layer 9 was formed on the adhesive interface layer. A bulk-copper-layer-forming bath 10 was filled with a copper sulfate solution having a free sulfuric acid concentration of 150 g/l and a copper concentration of 65 g/l and maintained at 45°C. The carrier foil 3 having an adhesive interface layer 8 was passed through the solution so as to form a bulk copper layer 9. In order to deposit copper uniformly and smoothly on the adhesive interface layer, as shown in Fig. 18, anode plates 11 were placed such that the anode plates faced one surface of the carrier foil 3 in parallel. Electrolysis was carried out for 60 seconds under smooth plating conditions and at a current density of 15 A/dm². In this case, at least one tension roll 12 maintaining contact with the running carrier foil 3 served as a current-supplier so as to polarize the carrier foil 3 *per* se to a cathode.

After formation of the bulk copper layer 9 was completed, the carrier foil 3 was transferred into a copper-microparticle-forming bath 14 in order to form copper microparticles 13 on the surface of the bulk copper layer 9. This treatment, carried out in the copper-microparticle-forming bath 14, involves depositing copper microparticles 13 on the bulk copper layer 9 (step 14A) and seal-plating so as to prevent release of the copper microparticles 13 (step 14B).

Step 14A, depositing copper microparticles 13 on the bulk copper layer 9, employed a copper sulfate solution (free sulfuric acid concentration of 100 g/l, copper concentration of 18 g/l, temperature 25°C) similar to that employed in the bulk-copper-layer-forming bath 10, and electrolysis was carried out for 10 seconds under conditions for forming burnt deposit at a current density of 10 A/dm². In this case, as shown in Fig. 18, anode plates 11 were placed such that the anodes plates faced the bulk-copper-layer-deposited surface of the carrier foil 3 in parallel.

Step 14B, seal-plating so as to prevent release of the copper microparticles 13, employed a copper sulfate solution (free sulfuric acid concentration of 150 g/l, copper concentration of 65 g/l, temperature 45°C) similar to that employed in the bulk-copper-layer-forming bath 10, and electrolysis was carried out for 20 seconds under seal plating conditions and at a current density of 15 A/dm². In this case, as shown in Fig. 18, anode plates 11 were placed such that the anode plates faced the copper-microparticles (13)-deposited surface of the carrier foil 3 in parallel.

Anti-corrosion treatment was carried out in an anti-corrosion-treatment bath 15, by use of zinc as a corrosion-inhibiting element. In the bath, a zinc plate serving as a soluble anode 16 was employed, to thereby maintain the concentrations of zinc in the anti-corrosion-treatment bath 15. The electrolysis was carried out in a zinc sulfate solution comprising free sulfuric acid (70 g/l) and zinc (20 g/l), at a temperature of 40°C for five seconds and a current density of 15 A/dm².

After completion of the anti-corrosion treatment, the carrier foil 3 was passed through, over 40 seconds, a drying portion 17 where the atmosphere had been heated to 110°C, to thereby produce an electrodeposited copper foil with carrier 1, which was then wound into a roll. During the aforementioned steps, the carrier foil ran at 2.0 m/minute. The foil was then washed with water in a water-rinsing bath 18 capable of performing about 15 sec. water-rinsing and disposed between successive operation baths, thereby preventing the solution from being carried over from the previous bath.

The thus-formed electrodeposited copper foil with carrier 1 and two sheets of FR-4 prepreg having a thickness of 150 µₘ were laminated to thereby produce a double-sided copper-clad laminate. The peel strength at the organic adhesive interface 8 between the carrier foil layer 3 and the electrodeposited copper foil layer 5 was measured. The average thickness of the adhesive interface layer was 8 nm. The results are shown in Tables 1 to 4.

Example 2: In the present embodiment, an electrodeposited copper foil with carrier 1 according to claim 9, which is shown in Fig. 10(a), will be described. An apparatus 2' for producing an electrodeposited copper foil with carrier 1 is shown in Fig. 19. In the apparatus, a carrier foil 3 is unwound from a foil roll and travels horizontally, in a floating manner, along the process line to thereby produce an electrodeposited copper foil layer 5. In the apparatus 2', divided anodes 11' were disposed in at least a bulk-copper-layer-forming bath 10 and in a surface-treatment bath 14 such that the anodes faced in parallel one surface of the carrier foil 3.

From slits formed by the divided anodes, an electrolyte is allowed to issue such that the carrier foil 3 can be floated and that the electrolyte contacts one surface of the carrier foil 3. Such slits are also formed by similar elements not necessarily anodes in other baths so as to float the carrier foil 3. Herein, a drum foil having a thickness of 70 µm and classified as grade 3 was employed as the carrier foil 3, and the electrodeposited copper foil layer 5 having a thickness of 5 µm was formed. Hereinafter, production conditions of electrodeposited copper foils with carrier will be described with reference to an apparatus wherein a variety of baths are continuously disposed in-line.

Firstly, the carrier foil 3 taken from the foil roll was transferred into a pickling bath 6 filled with a diluted free sulfuric acid solution having a concentration of 150 g/l and maintained at 30°C. The carrier foil was immersed for approximately 25 seconds, to remove oily matter and surface oxide film from one surface of the carrier foil 3.

After the carrier foil 3 had been treated in the pickling bath 6, the foil was passed over an adhesive-interface-forming bath 7 containing a 5 g/l aqueous solution of thiocyanuric acid (pH 5), at 40°C. The carrier foil 3 traveled horizontally while contacting an aqueous solution containing the organic agent which is allowed to issue from the adhesive-interface-forming bath 7 for 40 seconds, thereby forming on a surface of the carrier foil 3 an adhesive interface layer 8.

After the adhesive interface layer 8 had been formed, a bulk copper layer 9 was formed on the adhesive interface layer. A bulk-copper-layer-forming bath 10 contained a copper sulfate solution having a free sulfuric acid concentration of 150 g/l and a copper concentration of 65 g/l at 45°C. The carrier foil 3 having an adhesive interface layer 8 was passed over the solution to form a bulk copper layer 9. In order to deposit a bulk copper layer 9 uniformly and smoothly on the adhesive interface layer 8, as shown in Fig. 19, anode plates 11' were placed such that the anode plates faced in parallel one surface of the carrier foil 3. Electrolysis was carried out for 90 seconds under smooth plating conditions and at a current density of 10 A/dm². In this case, at least one tension roll 19 maintaining contact with the horizontally running carrier foil 3 served as a current-supplier so as to polarize the carrier foil 3 per *se* to a cathode.

After formation of the bulk copper layer 9 was completed, the carrier foil 3 was passed over a copper-microparticle-forming bath 14 in order to form copper microparticles 13 on the surface of the bulk copper layer 9. This treatment, carried out in the copper-microparticle-forming bath 14, involves depositing copper microparticles 13 on the bulk copper layer 9 (step 14A) and seal-plating so as to prevent release of the copper microparticles 13 (step 14B).

Step 14A, depositing copper microparticles 13 on the bulk copper layer 9, employed a copper sulfate solution (free sulfuric acid concentration of 100 g/l, copper concentration of 18 g/l, temperature 25°C) similar to that employed in the bulk-copper-layer-forming bath 10, and electrolysis was carried out for 15 seconds under conditions for forming burnt deposits at a current density of 10 A/dm². In this case, as shown in Fig. 19, the anode plates 11' were placed such that the anodes plates faced the bulk-copper-layer-deposited surface of the carrier foil 3 in parallel.

Step 14B, seal-plating so as to prevent release of the copper microparticles 13, employed a copper sulfate solution (free sulfuric acid concentration of 150 g/l, copper concentration of 65 g/l, temperature 45°C) similar to that employed in the bulk-copper-layer-forming bath 10, and electrolysis was carried out for 20 seconds under seal plating conditions and at a current density of 15 A/dm². In this case, as shown in Fig. 19, anode plates 11' were placed such that the anode plates faced the copper-microparticles (13)-deposited surface of the carrier foil 3 in parallel.

Anti-corrosion treatment was carried out over an anti-corrosion-treatment bath 15, by use of zinc as a corrosion-inhibiting element. In the bath, a zinc plate serving as a soluble anode 16' was employed, to thereby maintain the concentration of zinc in the anti-corrosion-treatment bath 15. The electrolysis was carried out by use of a zinc sulfate solution comprising free sulfuric acid (70 g/l) and zinc (20 g/l), at a temperature of 40°C for 20 seconds and a current density of 0.3 A/dm².

After completion of the anti-corrosion treatment, the carrier foil 3 was passed through, over 40 seconds, a drying portion 17 where the atmosphere had been heated to 110°C, to thereby produce an electrodeposited copper foil with carrier 1, which was then wound into a roll. During the aforementioned steps, the carrier foil ran at 2.0 m/minute. The foil was then washed with water which was allowed to issue from a water-rinsing bath 18 capable of performing about 15 sec. water-rinsing and disposed between successive operation baths, thereby preventing the solution from being carried over from the previous bath.

The thus-formed electrodeposited copper foil with carrier 1 and two sheets of FR-4 prepreg having a thickness of 150 µm were laminated to thereby produce a double-sided copper-clad laminate. The peel strength at the organic adhesive interface 8 between the carrier foil layer 3 and the electrodeposited copper foil layer 5 was measured. The average thickness of the adhesive interface layer was 8 nm. The results are shown in Tables 1 to 4.

Example 3: In the present embodiment, an electrodeposited copper foil with carrier 1 according to claim 10, which is shown in Fig. 13, will be described. An apparatus 2 employed in Example 3, shown in Fig. 18, was the same one employed in Example 1. In Example 3, the side of a carrier foil 3 unwound from a roll was reversed, and an electrodeposited copper foil layer 5 was formed on the matte side 20. The carrier foil travels, in a winding manner, along the process line to produce an electrodeposited copper foil layer 5. A drum foil having a thickness of 18 µₘ and classified as grade 3 was employed as the carrier foil 3, and the electrodeposited copper foil layer 5 having a thickness of 5 µm was formed.

Since production conditions employed in Example 3 are similar to those employed in Example 1, repeated description will be omitted and only essential and important points will be described. No substantial changes were made in relation to conditions for a pickling bath 6, an adhesive-interface-forming bath 7, and a drying portion 17. However, for the side onto which an electrodeposited copper foil layer 5 is formed on the matte side in Example 3, conditions for electrodepositing copper may be adjusted to a small degree.

In a bulk-copper-layer-forming bath 10, electrolysis was carried out for 10 seconds in a copper sulfate solution having a free sulfuric acid concentration of 150 g/l and a copper concentration of 65 g/l, at 45°C and a current density of 15 A/dm².

Step 14A, depositing copper microparticles 13 on the bulk copper layer 9, employed a copper sulfate solution (free sulfuric acid concentration of 100 g/l, copper concentration of 18 g/l, temperature 25°C) similar to that employed in the bulk-copper-layer-forming bath 10, and electrolysis was carried out for 10 seconds under conditions for forming burnt deposit at a current density of 10 A/dm².

Step 14B, seal-plating so as to prevent release of the copper microparticles 13, employed a copper sulfate solution (free sulfuric acid concentration of 150 g/l, copper concentration of 65 g/l, temperature 45°C) similar to that employed in the bulk-copper-layer-forming bath 10, and electrolysis was carried out for 20 seconds under smooth plating conditions and at a current density of 15 A/dm². Anti-corrosion treatment was carried out in an anti-corrosion-treatment bath 15 comprising a zinc sulfate solution containing free sulfuric acid (70 g/l) and zinc (20 g/l), at a temperature of 40°C for 20 seconds and a current density of 0.3 A/dm².

The thus-formed electrodeposited copper foil with carrier 1 and two sheets of FR-4 prepreg having a thickness of 150 µm were laminated to thereby produce a double-sided copper-clad laminate. The peel strength at the organic adhesive interface 8 between the carrier foil layer 3 and the electrodeposited copper foil layer 5 was measured. The average thickness of the adhesive interface layer was 8 nm. The results are shown in Tables 1 to 4.

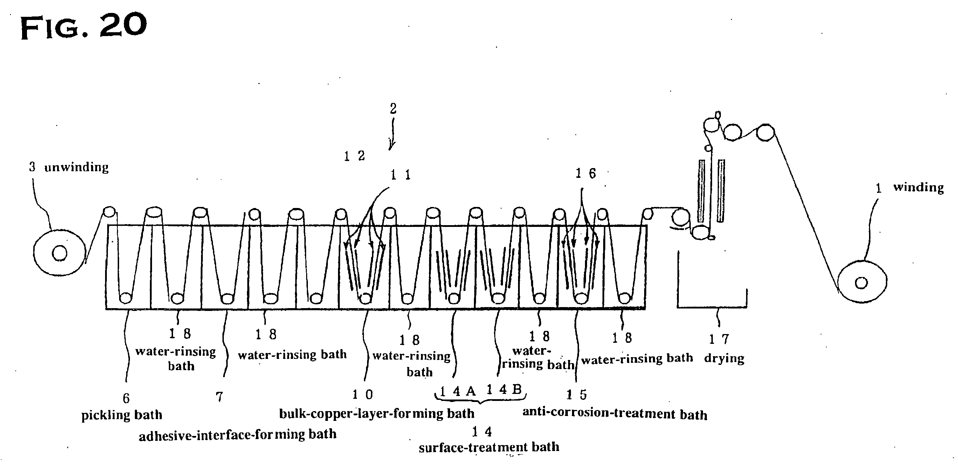

Example 4: In the present embodiment, an electrodeposited copper foil with carrier 1 according to claim 11, which is shown in Fig. 15, will be described. An apparatus 2 employed in Example 4 is shown in Fig. 20. In the apparatus, a carrier foil 3 is unwound from a foil roll and travels, in a winding manner, along the process line to thereby produce an electrodeposited copper foil layer 5. A drum foil having a thickness of 18 µm and classified as grade 3 was employed as the carrier foil 3, and the electrodeposited copper foil layer 5 having a thickness of 5 µm was formed on both the shiny side 4 and the matte side 20. Hereinafter, production conditions of electrodeposited copper foils with carrier will be described with reference to an apparatus wherein a variety of baths are continuously disposed in-line.

Since production conditions employed in Example 4 are similar to those employed in Example 1, repeated description will be omitted and only essential and important points will be described. No substantial changes were made in relation to conditions for a pickling bath 6, an adhesive-interface-forming bath 7, and a drying portion 17. However, an electrodeposited copper foil layer 5 is formed on both sides of the carrier foil 3 in Example 4, whereas the copper foil layer 5 is formed on only one side of the carrier foil in Example 1. Thus, the arrangement of anodes 11 for carrying out electrodeposition must be modified.

A bulk-copper-layer-forming bath 10 was filled with a copper sulfate solution having a free sulfuric acid concentration of 150 g/l and a copper concentration of 65 g/l, and maintained at 45°C. As shown in Fig. 20, anode plates 11 were placed such that the anode plates faced one surface of the carrier foil 3 in parallel, and a bulk copper layer 9 was deposited on the shiny side 4 and the matte side 20 of the carrier foil. Onto both sides, electrolysis was carried out for 60 seconds and a current density of 15 A/dm² under smooth plating conditions.

Step 14A, depositing copper microparticles 13 on the bulk copper layer 9, employed a copper sulfate solution (free sulfuric acid concentration of 100 g/l, copper concentration of 18 g/l, temperature 25°C) similar to that employed in the aforementioned bulk-copper-layer-forming bath 10, and electrolysis was carried out on the shiny side 4 and the matte side 20 for 10 seconds under conditions for forming burnt deposit at a current density of 10 A/dm². Arrangement of anodes 11 is identical with that employed for depositing a bulk copper layer.

Step 14B, seal-plating so as to prevent release of the copper microparticles 13, employed a copper sulfate solution (free sulfuric acid concentration of 150 g/l, copper concentration of 65 g/l, temperature 45°C) similar to that employed in the aforementioned bulk-copper-layer-forming bath 10, and electrolysis was carried out on the shiny side 4 and the matte side 20 for 20 seconds under seal plating conditions and at a current density of 15 A/dm².

Anti-corrosion treatment was carried out in an anti-corrosion-treatment bath 15 comprising a zinc sulfate solution. In the bath, a zinc plate serving as a soluble anode 16 was also employed, to thereby maintain the concentration of zinc in the anti-corrosion-treatment bath 15. The electrolysis was carried out in a zinc sulfate solution comprising free sulfuric acid (70 g/l) and zinc (20 g/l), at a temperature of 40°C and a current density of 0.3 A/dm². During the aforementioned steps, the carrier foil 3 ran at 2.0 m/minute.

The thus-formed electrodeposited copper foil with carrier 1 and two sheets of FR-4 prepreg having a thickness of 150 µₘ were laminated to thereby produce a double-sided copper-clad laminate. The peel strength at the organic adhesive interface 8 between the carrier foil layer 3 and the electrodeposited copper foil layer 5 was measured. The average thickness of the adhesive interface layer was 10 nm. The peel strength of the shiny side 4 and that of the matte side 20 are separately shown in Tables 1 to 4.

Example 5: In the present embodiment, an electrodeposited copper foil with carrier 1 according to claim 9, which is shown in Fig. 10(b), will be described. An apparatus 2 employed in Example 5 is shown in Fig. 18. In the apparatus, a carrier foil 3 is unwound from a foil roll and travels, in a winding manner, along the process line to thereby produce an electrodeposited copper foil layer. A surface-treated foil having a thickness of 18 µₘ and classified as grade 3 was employed as the carrier foil 3, and the electrodeposited copper foil layer 5 was formed on the shiny side 4.

Since production conditions employed in Example 5 are identical with those employed in Example 1, repeated description will be omitted.

A plurality of the thus-formed electrodeposited copper foils with carrier 1 and FR-4 prepregs having a thickness of 150 µm were laid-up and press-formed as shown in Fig. 6, thereby producing double-sided copper-clad laminates. In order to measure the peel strength at the organic adhesive interface 8 between the carrier foil layer 3 and the electrodeposited copper foil layer 5, copper-clad laminates which were to be subjected to measurement of peel strength were prepared. The average thickness of the adhesive interface layer 8 was 11 nm. The peel strength at the organic adhesive interface 8 between the carrier foil layer 3 and the electrodeposited copper foil layer 5 of the samples are shown in Tables 1 to 4.

In addition, the present inventors produced electrodeposited copper foils with carrier under conditions similar to those employed in Example 1, except that carboxybenzotriazole was employed in an adhesive-interface-forming bath 7 instead of thiocyanuric acid. These copper foils were subjected to measurement of peel strength, and the results are shown in Tables 1 to 4 in the columns of Comparative Example.

**[Table 1]**

| Heated at 250°C | | | | | | | |
|---|---|---|---|---|---|---|---|
| Samples | Measured | Peel strength at adhesive interface after heating (gf/cm) | | | | | |
| | Heating time | 0 min | 10 min | 30 min | 60 min | 90 min | 120 min |
| Example 1 | | 5.0 | 5.0 | 4.9 | 4.9 | 5.0 | 5.5 |
| Example 2 | | 4.5 | 4.8 | 5.0 | 4.7 | 5.2 | 5.5 |
| Example 3 | | 9.2 | 9.0 | 8.7 | 10.0 | 9.7 | 10.3 |
| Example 4 (shiny side) | | 5.1 | 5.0 | 5.0 | 5.0 | 4.9 | 5.7 |
| Example 4 (matte side) | | 10.0 | 10.2 | 9.9 | 9.9 | 10.3 | 10.9 |
| Example 5 | | 7.0 | 6.0 | 6.0 | 6.2 | 6.9 | 7.2 |
| Comp. Example | | 5.0 | 64.7 | 248.8 | not peeled | not peeled | not peeled |

**[Table 2]**

| Heated at 275°C | | | | | | | |
|---|---|---|---|---|---|---|---|
| Samples | Measured | Peel strength at adhesive interface after heating (gf/cm) | | | | | |
| | Heating time | 0 min | 10 min | 30 min | 60 min | 90 min | 120 min |
| Example 1 | | 5.0 | 5.4 | 4.4 | 3.9 | 9.8 | 21.8 |
| Example 2 | | 4.5 | 5.0 | 4.9 | 4.5 | 8.2 | 19.7 |
| Example 3 | | 9.2 | 9.0 | 8.7 | 9.2 | 16.9 | 28.8 |
| Example 4 (shiny side) | | 5.1 | 6.1 | 5.5 | 5.0 | 9.9 | 20.5 |
| Example 4 (matte side) | | 10.0 | 10.0 | 10.0 | 11.2 | 15.3 | 30.0 |
| Example 5 | | 7.0 | 8.2 | 6.7 | 7.0 | 10.0 | 25.2 |
| Comp. Example | | 5.0 | not peeled | not peeled | not peeled | not peeled | not peeled |

**[Table 3]**

| Heated at 300°C | | | | | | | |
|---|---|---|---|---|---|---|---|
| Samples | Measured | Peel strength at adhesive interface after heating (gf/cm) | | | | | |
| | Heating time | 0 min | 10 min | 30 min | 60 min | 90 min | 120 min |
| Example 1 | | 5.0 | 5.8 | 10.2 | 9.1 | 20.0 | 22.6 |
| Example 2 | | 4.5 | 5.5 | 12.1 | 15.0 | 20.0 | 21.8 |
| Example 3 | | 9.2 | 11.1 | 17.8 | 23.3 | 30.4 | 40.7 |
| Example 4 (shiny side) | | 5.1 | 5.4 | 8.3 | 10.6 | 20.0 | 23.0 |
| Example 4 (matte side) | | 10.0 | 11.1 | 15.7 | 19.2 | 25.5 | 33.3 |
| Example 5 | | 7.0 | 10.0 | 19.9 | 25.3 | 32.3 | 45.7 |
| Comp. Example | | 5.0 | not peeled | not peeled | not peeled | not peeled | not peeled |

**[Table 4]**

| Heated at 360°C | | | | | | | |
|---|---|---|---|---|---|---|---|
| Samples | Measured | Peel strength at adhesive interface after heating (gf/cm) | | | | | |
| | Heating time | 0 min | 10 min | 30 min | 60 min | 90 min | 120 min |
| Example 1 | | 5.0 | 9.0 | 26.3 | 43.5 | 80.0 | 104.5 |
| Example 2 | | 4.5 | 14.4 | 28.8 | 25.2 | 88.8 | 110.0 |
| Example 3 | | 9.2 | 22.1 | 34.4 | 51.3 | 97.2 | 150.4 |
| Example 4 (shiny side) | | 5.1 | 9.9 | 32.1 | 49.9 | 89.9 | 110.7 |
| Example 4 (matte side) | | 10 | 18.9 | 33.3 | 53.6 | 100.1 | 133.3 |
| Example 5 | | 7.0 | 23.5 | 43.7 | 63.1 | 102.0 | 157.3 |
| Comp. Example | | 5.0 | not peeled | not peeled | not peeled | not peeled | not peeled |

As is clear from the results, the electrodeposited copper foils with carrier produced in Examples 1 to 4 exhibit a considerably low peel strength at the adhesive interface between the carrier foil and the electrodeposited copper foil, and the peel strength is more stable than that of conventional electrodeposited copper foils with peelable carrier, even after the foils are heated to high temperature. Thus, the electrodeposited copper foils with carrier can be employed in a manner which has never been attained. The present inventors have further investigated 30 or more lots of products corresponding to each embodiment of the present invention, and have found that the peel strength is maintained at 200 gf/cm or less before heating, and even after heating at 225-360°C. In all cases, no peel failure was observed.

### Effects of the Invention

In the electrodeposited copper foil with carrier according to the present invention, a carrier foil can be peeled off from an electrodeposited copper foil layer by application of a considerably small peeling force at the interface therebetween. Thus, the peel stability at the interface can be maintained even after the foil is treated at high temperature. Such a feature has never been attained by use of conventional electrodeposited copper foils with peelable carrier. In addition, since the peel strength of the adhesive interface is maintained at a low level even after the foil is treated at high temperature, the electrodeposited copper foil with carrier can readily be employed for producing high-temperature-press-formed substrates such as an adhesive-less polyimide substrate and a Teflon substrate.

## Claims

1. An electrodeposited copper foil with carrier comprising a carrier foil, an organic adhesive interface layer formed on one surface of the carrier foil, and an electrodeposited copper layer serving as a copper foil deposited on the adhesive interface layer, wherein the organic adhesive interface layer is formed by use of thiocyanuric acid.

2. An electrodeposited copper foil with carrier comprising a carrier foil, an adhesive interface layer formed by use of thiocyanuric acid on both surfaces of the carrier foil, and an electrodeposited copper layer serving as a copper foil deposited on each surface of the adhesive interface layer.

3. An electrodeposited copper foil with carrier comprising a carrier foil, an adhesive interface layer formed by use of thiocyanuric acid on one surface of the carrier foil, and copper microparticles alone electrodeposited on the adhesive interface layer, the deposited copper microparticles serving as an electrodeposited copper foil.

4. An electrodeposited copper foil with carrier comprising a carrier foil, an adhesive interface layer formed by use of thiocyanuric acid on each surface of the carrier foil, and copper microparticles alone electrodeposited on each adhesive interface layer, the deposited copper microparticles serving as an electrodeposited copper foil.

5. An electrodeposited copper foil with carrier according to any one of claims 1 through 4, wherein the adhesive interface layer is formed by use of thiocyanuric acid, through repeated application of thiocyanuric acid.

6. An electrodeposited copper foil with carrier according to any one of claims 1 through 5, wherein the adhesive layer is formed of thiocyanuric acid and has a thickness of 1 nm to 1 µm.

7. An electrodeposited copper foil with carrier according to any one of claims 1 through 6, wherein the carrier foil is electrodeposited copper foil having a thickness of 12 µm to 210 µm..

8. An electrodeposited copper foil with carrier according to claim 7, wherein an adhesive interface layer is formed on a shiny side of an electrodeposited copper foil serving as a carrier foil, by use of thiocyanuric acid, and an electrodeposited copper foil layer is deposited on the adhesive interface layer.

9. An electrodeposited copper foil with carrier according to claim 7, wherein an adhesive interface layer is formed on a matte side of an electrodeposited copper foil serving as a carrier foil, by use of thiocyanuric acid, and an electrodeposited copper foil layer is deposited on the adhesive interface layer.

10. An electrodeposited copper foil with carrier according to claim 7, wherein an adhesive interface layer is formed on both a shiny side and a matte side of an electrodeposited copper foil serving as a carrier foil, by use of thiocyanuric acid, and an electrodeposited copper foil layer is deposited on each adhesive interface layer.

11. A method for producing an electrodeposited copper foil with carrier, said electrodeposited copper foil with carrier as defined in claims 1 to 10, which method comprises unwinding a rolled carrier foil from one direction and passing the carrier foil in an apparatus wherein baths for forming an electrodeposited copper foil layer are continuously disposed in-line, the baths including a pickling bath, an adhesive-interface-forming bath containing thiocyanuric acid, a bath for forming a bulk copper layer to serve as an electrodeposited copper foil layer, a nodular-treatment bath for depositing copper microparticles on the bulk copper layer, an anti-corrosion-treatment bath, and a drying portion, with water-rinsing baths appropriately provided, to thereby continuously form a thiocyanuric acid adhesive interface layer and an electrodeposited copper layer on the carrier foil.

12. A copper-clad laminate or a printed wiring board which is obtained through use of an electrodeposited copper layer on with carrier as recited in any one of claims 1 through 10.
